# EUROPEAN PATENT SPECIFICATION

(11) **EP 3 173 508 B1**
(45) Date of publication and mention of the grant of the patent: **28.10.2020**
(21) Application number: 15825092.8
(22) Date of filing: 15.07.2015
(51) Int. Cl.: C23C 18/30, B29C 45/00, C23C 18/20, C23C 18/16, C23C 18/40, C23C 18/28

(54) **METHOD FOR PRODUCING PLATED COMPONENT**
VERFAHREN ZUR HERSTELLUNG EINES PLATTIERTEN ARTIKELS
PROCÉDÉ DE FABRICATION D'UN COMPOSANT PLAQUÉ

(30) Priority: 24.07.2014 JP 2014150284; 25.06.2015 JP 2015128004
(43) Date of publication of application: 31.05.2017
(73) Proprietor: Maxell Holdings, Ltd., Kyoto 618-8525 (JP)
(72) Inventor: KITO, Akiko, Otokuni-gun, Kyoto 618-8525 (JP); YUSA, Atsushi, Otokuni-gun, Kyoto 618-8525 (JP); USUKI, Naoki, Otokuni-gun, Kyoto 618-8525 (JP); YAMAMOTO, Satoshi, Otokuni-gun, Kyoto 618-8525 (JP); GOTO, Hideto, Otokuni-gun, Kyoto 618-8525 (JP); SUENAGA, Masashi, Otokuni-gun, Kyoto 618-8525 (JP)
(74) Representative: SSM Sandmair
(86) International application number: PCT/JP2015/070243
(87) International publication number: WO 2016/013464

(56) References cited:
- EP-A1- 2 124 514
- EP-A1- 2 197 253
- WO-A1-2010/068104
- JP-A- 2006 057 166
- JP-A- 2006 228 951
- JP-A- 2010 021 190
- US-A- 3 930 963
- US-A- 4 096 043

## Description

### TECHNICAL FIELD

The present invention relates to a method for producing a plated part (plated component) on which a plating film is selectively formed.

### BACKGROUND ART

In recent years, a three-dimensional circuit formed part, in which an electric circuit is formed on a surface of an injection-molded product or the like, is referred to as "MID (Molded Interconnect Device), and its application range is rapidly expanded. In the case of MID, it is possible to form the circuit on the surface of the molded product having a small size and a complicated shape. Therefore, MID is in consistency with the trend of compactization (miniaturization) of electronic parts. For example, a small-sized part, in which an antenna or the like is formed on a surface of a casing of a smartphone, is mass-produced in China. Further, the application of MID to sensors and lighting parts is also actively investigated in the field of automobile principally in Europe. Further, at present, a large amount of cable harness (wire harness) is used for the automobile. If the cable harness is replaced with MID, it is thereby possible to expect the decrease in the cost by realizing a light weight and reducing the number of assembling steps.

A method explained below is suggested, for example, as a method for forming a wiring pattern (electric circuit) on a surface of an insulating base member such as a resin molded product or the like. At first, a metal layer is formed on the entire surface of the base member. Subsequently, the formed metal layer is subjected to the patterning with a photoresist, and then the metal layer of a portion other than the wiring pattern is removed by means of the etching. Accordingly, the wiring pattern can be formed by the metal layer allowed to remain on the surface of the base member.

Further, a method, in which a laser beam is used, is suggested as a method for forming a wiring pattern (electric circuit) without using any photoresist (for example, Patent Document 1). At first, a laser beam is radiated onto a portion at which it is intended to form the wiring pattern, and thus the base member is roughened. Then, when an electroless plating catalyst is applied to the whole of the base member, the electroless plating catalyst strongly adheres to the portion irradiated with the laser beam as compared with the other portions. Subsequently, when the base member is washed, then the electroless plating catalyst remains at only the portion irradiated with the laser beam, and the catalyst having been present at the other portions can be removed with ease. The electroless plating is applied to the base member on which the electroless plating catalyst adheres to only the portion irradiated with the laser beam, and thus a plating film can be formed on only the portion irradiated with the laser beam, i.e., on only the predetermined wiring pattern. In the case of the method for forming the wiring pattern based on the use of the laser beam, it is possible to omit the labor and the cost for producing a photomask or the like, and hence it is easy to change the wiring pattern.

An LDS (Laser Direct Structuring) method is practically applied as another method for forming a wiring pattern (electric circuit) (for example, Non-Patent Document 1 and Patent Document 2). In the case of the LDS method, a copper complex is kneaded into a thermoplastic resin to perform the injection molding, and the laser drawing is performed on a surface of a molded product containing the copper complex. The copper complex is converted into the metal by being irradiated with the laser beam, the catalytic activity of the electroless copper plating is expressed, and it is possible to plate the portion subjected to the laser drawing. The LDS method makes it possible to produce a three-dimensional circuit formed part (MID) in which a circuit is formed on a surface of an injection-molded product having a complicated shape. The LDS method comes into widespread use in the production of smartphones and automobiles.

A method, which is different from the method for kneading the catalyst into the molded product like the LDS method, is also suggested (for example, Patent Document 3). Patent Document 3 discloses a method in which a functional group is applied to a surface of a molded product by using a femto-second laser beam having a short wavelength. The surface of the molded product has a polar group, and hence the chemical adhesion strength is expressed with respect to the plating film. Other methods for producing a plated part are disclosed in Patent Documents 4 and 5.

### PRECEDING TECHNICAL DOCUMENTS

### Patent Documents:

Patent Document 1: Japanese Patent No. 3222660
Patent Document 2: European Patent No. 1274288
Patent Document 3: Japanese Patent Application Laid-open No. 2012-136769
Patent Document 4: US patent US4096043
Patent Document 5: European Patent EP 2 197 253

Non-Patent Document: Wolfgang John, "Three-dimensional components for reducing production cost", Industrial Laser Solutions Japan, e. x. press, September 2011, p. 18-22

### SUMMARY OF THE INVENTION

### Task to be Solved by the Invention:

However, in the case of the method for forming the wiring pattern (electric circuit) by utilizing the laser beam as suggested in Patent Document 1, the electroless plating catalyst strongly adheres to the portions other than the portion irradiated with the laser beam depending on the type and the surface state of the base member, and the electroless plating catalyst cannot be removed even by performing the washing in some cases. For example, the electroless plating catalyst easily adheres to, for example, a base member which contains a filler that easily causes the adhesion of the electroless plating catalyst, a base member which has a large surface roughness, and a base member which has any void. Therefore, the electroless plating catalyst easily remains thereon even when the washing is performed. Further, the electroless plating catalyst permeates into the inside of the base member in some cases depending on the type of the electroless plating catalyst and the type of the base member. It has been difficult to remove the electroless plating catalyst having permeated into the base member by means of the washing. Then, if the electroless plating is applied to the base member in which the electroless plating catalyst remains at the portions other than the predetermined wiring pattern as described above, then an electroless plating film is generated at the portions other than the wiring pattern as a matter of course, and any problem arises.

Further, in the case of the LDS method, it is necessary to develop an exclusively usable resin. A problem arises such that the cost of the resin material is greatly increased. Then, the resin is colored due to the kneading of the large amount of the copper complex into the resin, and hence it has been difficult to apply the LDS method to transparent resins. Further, when the LDS method is applied, for example, to a sheet-shaped thin-walled molded product, it has been difficult to mass-produce a variety of products in small amounts, because it is necessary to use exclusively usable resins. Further, if it is intended to apply the LDS method to the production of a large-sized part such as a substitute or replacement part for the cable harness of the automobile or the like, the following problem arises. At first, the amount of the exclusively usable resin material to be consumed is increased, and hence the cost is raised. Then, it is necessary to realize a large-sized laser apparatus, which causes a problem in relation to the mass production. Further, the wiring patterns are adjacent to one another on an identical substrate, and hence it is also feared that the insulation performance can be secured between the wiring patterns.

On the other hand, in Patent Document 3, it is investigated that the molded product surface is selectively plated without using any special resin material. However, it is difficult to provide any distinct contrast for the surface characteristic of the molded product between the drawn portion and the other portions by means of only the laser drawing. It is considered to be difficult to stably perform the selective plating by means of the method of Patent Document 3. Further, the method of Patent Document 3 requires an expensive short wavelength laser machining machine. This fact prohibits the widespread use of the method.

The present invention solves the problems as described above, which provides a method for producing a plated part wherein the method hardly depends on the type, the shape, and the state of a base member, the method suppresses the formation of any electroless plating film at portions other than a predetermined pattern in accordance with a simple and easy production process, and the electroless plating film can be formed at only the predetermined pattern.

### Solution for the Task:

According to the present invention, there is provided a method for producing a plated part (plated component), including applying a catalyst inactivator to a surface of a base member; irradiating with light or heating a part of the surface of the base member to which the catalyst inactivator is applied; allowing the surface of the base member to retain an electroless plating catalyst; and bringing an electroless plating solution into contact with the surface of the base member retaining the electroless plating catalyst to form an electroless plating film at a light-irradiated portion or a heated portion of the surface.

In the present invention, the catalyst inactivator (catalyst deactivator) may be any one of iodine, zinc, lead, tin, bismuth, antimony, and a compound thereof. The catalyst inactivator may permeate into or adsorb to the base member by applying the catalyst inactivator to the surface of the base member. Further, the applying of the catalyst inactivator to the surface of the base member may include preparing a catalyst inactivator solution containing the catalyst inactivator and a solvent; and immersing the base member in the catalyst inactivator solution. Then, when the catalyst inactivator is iodine, and the catalyst inactivator solution is an iodine solution; then the iodine solution may further contain an iodide ion.

In the present invention, the catalyst inactivator may be removed from the light-irradiated portion or the heated portion of the surface by irradiating with light or heating the part of the surface of the base member. In the present invention, the electroless plating catalyst may be applied to the surface of the base member after the part of the surface of the base member is heated or after the part of the surface of the base member is irradiated with light. Alternatively, the part of the surface of the base member may be irradiated with light or heated after the electroless plating catalyst is applied to the surface of the base member.

In the present invention, the base member may be a molded product containing the electroless plating catalyst; the method for producing the plated part may further include molding the molded product containing the electroless plating catalyst; and the allowing of the surface of the base member to retain the electroless plating catalyst may be performed by molding the molded product containing the electroless plating catalyst. Then, the molding of the molded product containing the electroless plating catalyst may include producing a first resin pellet containing the electroless plating catalyst and a block copolymer having a hydrophilic segment; and molding the molded product by using the first resin pellet and a thermoplastic resin.

Further, the irradiating with light or heating of the part of the surface of the base member may be performing laser drawing on the surface of the base member by using a laser beam.

In the present invention, the base member may have an area in which a predetermined first pattern is formed by protrusions and/or recesses extending on the surface; the catalyst inactivator may be applied to the area; and the protrusions and/or the recesses, which form the first pattern, may be irradiated with light or heated. The base member may have the area in which the predetermined first pattern is formed by the protrusions extending on the surface; and the protrusions may be heated by bringing a heating plate into contact with the protrusions which form the first pattern. Further, a second pattern, which corresponds to the first pattern of the base member, may be formed on a surface of the heating plate by protruding portions existing on the surface; and the second pattern, which is formed by the protruding portions of the heating plate, may be brought into contact with the first pattern which is formed by the protrusions of the base member to thermally press the base member by the heating plate so that the protrusions are heated and depressions are formed at top portions of the protrusions.

The present invention may further include removing the catalyst inactivator from the base member after the electroless plating catalyst is retained or after the electroless plating film is formed. Further, when the catalyst inactivator is iodine; the method may further include performing a reduction treatment for reducing at least a part of the iodine contained in the base member, after the electroless plating catalyst is retained or after the electroless plating film is formed. The method may further include removing, from the base member, an iodine compound produced by the reduction treatment.

In the present invention, the electroless plating catalyst may contain Pd, and the base member may be a resin. Further, the electroless plating film may form an electric circuit on the base member, and the plated part may be an electronic part (electronic component).

### EFFECT OF THE INVENTION

In the present invention, the electroless plating film is formed at the heated portion or the light-irradiated portion of the base member surface, while the generation (formation) of the electroless plating film is suppressed on account of the presence of the catalyst inactivator at the portions other than the above. Accordingly, in the method for producing the plated part of the present invention, the generation of the electroless plating film is suppressed at the portions other than the predetermined pattern in accordance with the simple and easy production process, and it is possible to form the electroless plating film at only the predetermined pattern. Further, in the method of the present invention, the range of selection of the base member is wide, and it is also possible to reduce the production cost.

### BRIEF DESCRIPTION OF THE DRAWINGS

Fig. 1 shows a flow chart illustrating a method for producing a plated part according to a first embodiment.
Fig. 2 shows a flow chart illustrating a method for producing a plated part according to a second embodiment.
Fig. 3 shows a photograph of a plated part (three-dimensional circuit part, MID) produced in Example 3.
Fig. 4 shows a photograph of a plated part formed with a wiring model pattern produced in Example 4.
Fig. 5 shows an enlarged photograph of a circuit pattern having a pitch of 500 µm in Area B shown in Fig. 4.
Fig. 6(a) schematically shows an entire base member used in the third embodiment, and Fig. 6(b) shows a sectional view illustrating those disposed in the vicinity of protrusions and recesses of the base member.
Figs. 7(a) to 7(c) explain a method for producing the plated part according to the third embodiment.
Figs. 8(a) to 8(c) explain a method for producing a plated part of a first modified embodiment of the third embodiment.
Fig. 9 schematically shows an entire plated part of the first modified embodiment of the third embodiment.
Fig. 10 shows a sectional view illustrating those disposed in the vicinity of protrusions and recesses of a plated part of a second modified embodiment of the third embodiment.
Fig. 11 shows a sectional view illustrating those disposed in the vicinity of protrusions and recesses of a plated part of a third modified embodiment of the third embodiment.

### MODE FOR CARRYING OUT THE INVENTION

### [First embodiment]

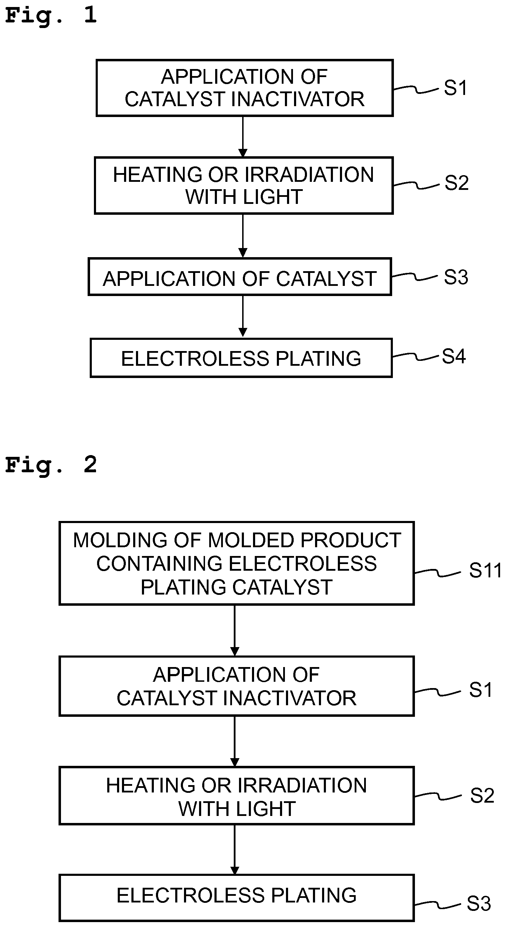

An explanation will be made in accordance with a flow chart shown in Fig. 1 about a method for producing a plated part (plated component) in which a plating film having a predetermined pattern is formed on a base member. At first, a catalyst inactivator is applied to the surface of the base member (Step S1 shown in Fig. 1). The material of the base member is not specifically limited. However, it is preferable to use an insulator in view of the formation of the electroless plating film on the surface. It is possible to use, for example, thermoplastic resin, thermosetting resin, photocurable resin, ceramics, and glass. Especially, the base member to be used in this embodiment is preferably a resin base member formed of resin, in view of the easiness of molding and the easiness of permeation of the catalyst inactivator.

As for the thermoplastic resin, it is possible to use polyamides including, for example, nylon 6 (PA6), nylon 66 (PA66), nylon 12 (PA12), nylon 11 (PA11), nylon 6T (PA6T), nylon 9T (PA9T), 10T nylon, 11T nylon, nylon MXD6 (PAMXD6), nylon 9T-6T copolymer, and nylon 6-66 copolymer. As for the resin other than polyamide, it is possible to use, for example, polypropylene, polymethyl methacrylate, polycarbonate, amorphous polyolefin, polyether imide, polyethylene terephthalate, polyether ether ketone, ABS-based resin, polyphenylene sulfide, polyamide imide, polylactic acid, and polycaprolactone.

In particular, when a plated part having the solder reflow resistance is produced, it is preferable to use aromatic nylon such as nylon 6T (PA6T), nylon 9T (PA9T), 10T nylon, 11T nylon, nylon MXD6 (PAMXD6) and the like and copolymers containing them, as the thermoplastic resin which is provided with both of the heat resistance and the moldability. Then, in view of the improvement in the dimension stability and the rigidity, an inorganic filler such as a glass filler, a mineral filler or the like may be charged into the thermoplastic resin as described above. Specifically, it is possible to use, for example, Amodel (product name) produced by Solvay Advanced Polymers, Genestar (product name) produced by Kuraray, Vylon Amide (product name) produced by Toyobo, and Reny (product name) produced by Mitsubishi Engineering-Plastics Toyobo. Further, when the solder reflow resistance is not required for the plated part, it is possible to use, for example, as a general purpose engineering plastic, ABS resin, polycarbonate (PC), and polymer alloy of ABS resin and PC (ABS/PC). Further, when a commercially available thermoplastic resin is used, it is also allowable to use a black thermoplastic resin which is commercially available as the black grade, in order that the heat is easily generated by absorbing the laser beam in the laser beam irradiation step as the aftertreatment step.

As for the thermosetting resin, it is possible to use, for example, silicone resin and epoxy resin. When a transparent thermosetting resin is used, it is thereby possible to produce a device (plated part) which is transparent and which has the solder reflow resistance. As for the photocurable resin, it is possible to use, for example, acrylic resin, silicone resin, epoxy resin, and polyimide. Further, as for the ceramics, it is possible to use, for example, alumina, aluminum nitride, lead titanate zirconate (PZT), barium titanate, and silicon wafer.

In order that the heat is easily generated by absorbing the laser beam in the laser beam irradiation step as the aftertreatment step, the base member may contain, as a light absorbing agent, a filler such as carbon and the like, and/or a light-absorbing coloring matter such as cyanine compound, phthalocyanine compound, dithiol metal complex, naphthoquinone compound, diimmonium compound, azo compound and the like. The light absorbing agent may be dissolved or dispersed in a solvent or the like, which may be applied to the base member surface. Alternatively, the light absorbing agent may be contained in a catalyst inactivator solution as described later on, which may be permeated into the base member together with the catalyst inactivator. However, it is preferable that the light absorbing agent is previously contained in the base member in view of the simplicity and convenience of the operation.

The base member, which is used in this embodiment, may be a commercially available product. Alternatively, the base member may be produced from a commercially available material by means of the molding or the like. For example, it is also allowable to produce a ceramics base member having a complicated shape in accordance with the powder injection molding method. Further, it is also allowable to produce a resin molded product (base member) by molding a commercially available thermoplastic resin into a desired shape. As for the method for molding the thermoplastic resin, it is possible to use the general purpose injection molding method and the extrusion molding method. The resin molded product may be a sheet-shaped molded product produced by the extrusion molding. Further, the base member may be shaped with a 3D printer by using a photocurable resin or a thermoplastic resin. When the 3D printer is used, it is possible to produce the base member having a complicated shape. It is possible to produce MID having a complicated shape by using this base member.

In this embodiment, the generation of the plating film is suppressed by the catalyst inactivator at the portions other than the predetermined pattern on the base member surface. Therefore, it is also possible to use those having been unsuccessfully used by the conventional method, including, for example, a base member containing a filler to which the electroless plating catalyst easily adheres, a base member which has a large surface roughness, and a base member which has any void. It is also possible to use, as the base member, transparent resin, thermosetting resin, ceramics, and glass, provided that the catalyst inactivator can permeate into or adsorb to the surface of the base member. Further, unlike the conventional LDS method, the base member can be produced by using the general purpose thermoplastic resin as it is. Therefore, it is possible to decrease the cost to a great extent. It is also possible to respond to the production of various types of sheet-shaped molded products in small amounts. In this way, the range of selection of the base member is wide in the method for producing the plated part of this embodiment. Accordingly, in the method for producing the plated part of this embodiment, any three-dimensional circuit formed product, which has a shape of any thin-walled sheet or any optical member including, for example, lenses and spectacles and which has been hitherto difficult to be produced, can be produced in accordance with the simple and easy method.

As for the catalyst inactivator, it is possible to use any arbitrary substance, provided that the substance prevents the electroless plating catalyst from exerting the catalytic ability and the substance consequently suppresses the reaction of the electroless plating. It is speculated that the catalyst inactivator directly reacts with the electroless plating catalyst to poison the electroless plating catalyst. The catalyst inactivator as described above is exemplified, for example, by heavy metals to serve as the plating catalyst poison such as zinc (Zn), lead (Pb), tin (Sn), bismuth (Bi), antimony (Sb) and the like and compounds thereof, iodine and compounds thereof, and oxidizing agents such as peroxides and the like. Especially, zinc (Zn), lead (Pb), tin (Sn), bismuth (Bi), and antimony (Sb) and compounds thereof are preferred in view of the strong poisonous property with respect to the electroless plating catalyst. Iodine is preferred in view of the high permeability into the resin base member.

The method for applying the catalyst inactivator to the base member surface is not specifically limited. For example, when the catalyst inactivator, which has the sublimability like solid iodine, is used, the following procedure is also available. That is, the base member and the catalyst inactivator are accommodated in a hermetically sealed vessel, the catalyst inactivator is sublimed by means of the heating or the like, and the sublimed gaseous catalyst inactivator is brought into contact with the base member. As another method, it is also allowable that a catalyst inactivator solution, in which the catalyst inactivator is dissolved or dispersed, is brought into contact with the base member. The method for bringing the catalyst inactivator solution into contact with the base member includes, for example, the application of the catalyst inactivator solution to the base member and the immersion of the base member in the catalyst inactivator solution. Especially, it is preferable to use the method for bringing the catalyst inactivator solution into contact with the base member, in view of the uniformity of the application of the catalyst inactivator and the simplicity and convenience of the operation. It is more preferable to use the method for immersing the base member in the catalyst inactivator solution. In view of the suppression of the generation of the electroless plating film at the portions other than the predetermined pattern, it is preferable that the catalyst inactivator is applied to the area of the base member surface to be brought into contact with at least the electroless plating solution in the electroless plating step described later on. It is more preferable that the catalyst inactivator is applied to the entire surface of the base member.

The blending amount of the catalyst inactivator (catalyst inactivator concentration) in the catalyst inactivator solution is not specifically limited. However, if the catalyst inactivator concentration is excessively low, it is difficult to allow the catalyst inactivator to permeate into or adsorb to the base member. Further, for example, when iodine is used as the catalyst inactivator, if the iodine concentration is excessively high, then the amount of iodine remaining in the base member is increased, and it is feared that the plating film may be corroded after the formation of the plating film. Therefore, the catalyst inactivator concentration in the catalyst inactivator solution can be determined depending on the easiness of permeation of the catalyst inactivator into the base member to be used or the easiness of adsorption thereto. However, for example, it is preferable that the catalyst inactivator concentration in the catalyst inactivator solution is 0.01% by weight to 12% by weight.

The solvent (medium), which is used for the catalyst inactivator solution, is not specifically limited, provided that the catalyst inactivator can be dissolved or dispersed in the solvent and the solvent does not change the quality of the base member. It is preferable to use, for example, water, alcohol, and a mixture thereof. As for alcohol, it is possible to use, for example, methanol, ethanol, propyl alcohol, isopropyl alcohol, and butanol.

When iodine is used as the catalyst inactivator, it is preferable that the iodine solution, which is the catalyst inactivator solution, contains iodide ions (I⁻) together with iodine molecules (I₂). For example, when the iodine solution contains an iodide salt such as sodium iodide, potassium iodide, ammonium iodide or the like, the iodine solution can thereby contain the iodide ion (I⁻) originating from the salt. It is speculated that the iodide ion (I⁻) is bound to iodine (I₂) in the iodine solution to form triiodide ion (I₃⁻). Accordingly, iodine is easily dissolved in the solvent, and the permeability of iodine into the base member is improved as well. The blending amount of the iodide salt in the iodine solution can be appropriately determined depending on the concentration of the iodine molecule (I₂) and the type of the base member. However, the blending amount can be, for example, 0.03% by weight to 40% by weight.

The catalyst inactivator solution of this embodiment may further contain a surfactant in order to improve the affinity for the base member. Further, the catalyst inactivator solution may contain a light absorbing agent such as carbon, cyanine compound, phthalocyanine compound, and azo compound. Accordingly, the base member, into which the catalyst inactivator solution permeates, absorbs the light such as the laser beam or the like to easily generate the heat. The catalyst inactivator solution of this embodiment can be prepared by mixing the catalyst inactivator, the solvent, and optionally, for example, the iodide salt and the surfactant or the like as described above in accordance with any conventionally known method.

The temperature of the catalyst inactivator solution, which is provided when the base member is immersed, is not specifically limited. However, for example, in view of the facilitation of the adsorption and the permeation of the catalyst inactivator with respect to the base member, the temperature is preferably not less than room temperature and not more than 80°C. The time of immersion of the base member in the catalyst inactivator solution can be appropriately determined depending on the concentration of the catalyst inactivator and the type of the base member. However, the immersion time is preferably 10 seconds to 1 hour.

Note that it is speculated that the catalyst inactivator, which is applied to the base member surface, permeates into the base member or adsorbs to the base member surface. When the resin base member is used as the base member, and iodine, which has the high permeability into the resin base member, is used as the catalyst inactivator, then it is speculated that iodine permeates into the resin base member. When iodine is used as the catalyst inactivator, it is speculated that iodine, which permeates into the base member, exists in the base member in such a situation that a state of iodine molecule (I₂), a state in which the oxidation number is -1 (minus 1) (I⁻), and a state in which the these states are combined (I₃⁻) are present in a mixed manner.

Further, when the catalyst inactivator is adsorbed to the base member surface, it is also appropriate that a silane coupling agent, which reacts with the base member, is applied to the base member surface in order to facilitate the adsorption of the catalyst inactivator to the base member. For example, a solution, in which the silane coupling agent is dissolved, is applied to the base member surface, and then the base member and the silane coupling agent are reacted with each other by means of the heating so that the silane coupling agent is immobilized on the base member surface. The method for applying the silane coupling agent solution is exemplified, for example, by methods of dip coat, screen coat, and spray coat. After the silane coupling agent is immobilized on the base member surface, the catalyst inactivator is applied to the base member surface.

Subsequently, the part of the base member surface to which the catalyst inactivator is applied is irradiated with light, or the part of the base member surface is heated (Step S2 shown in Fig. 1). The method for radiating the light is a method in which a laser beam is radiated onto the base member surface in accordance with a predetermined pattern (laser drawing). It is speculated that the light is converted into the heat by irradiating the part of the base member surface with the light, and the base member surface is heated. As described above, when the base member contains the light absorbing agent, the light, which is radiated onto the base member, can be efficiently converted into the heat. Further, when iodine is used as the catalyst inactivator, it is also allowable to use, as the light to be radiated onto the base member surface, light having a wavelength in the vicinity of 409 nm which is the absorption wavelength of iodine (I₂) and light in the vicinity of 397 nm which is the absorption wavelength of I₃⁻. In this case, iodine or the like contained in the base member can absorb the light. Further, the method for heating the base member surface without radiating any light onto the surface of the base member is exemplified, for example, by a method in which the base member surface is directly thermally pressed with a simple and elementary mold or the like having a pattern formed by protrusions. In view of the simplicity and convenience of the operation and the selectivity of the heated portion, it is preferable to heat the base member by means of the laser drawing.

The laser beam can be radiated by using a laser apparatus including, for example, a CO₂ laser, a YVO₄ laser, and a YAG laser. The laser apparatuses as described above can be selected depending on the type of the base member. For example, when the base member is a transparent resin molded product of, for example, polycarbonate (PC), polymethyl methacrylate (PMMA), silicone resin, and epoxy resin, it is preferable to use a laser light source such as the CO₂ laser (carbon dioxide gas laser) which is easily absorbed by the transparent resin molded product.

The portion irradiated with the laser beam is heated by radiating the laser beam onto the base member surface in accordance with the predetermined pattern (laser drawing), and the catalyst inactivator existing at the heated portion is removed. In this case, the phrase "removal of the catalyst inactivator" means, for example, such a situation that the catalyst inactivator existing at the heated portion disappears on account of the evaporation or the sublimation. Therefore, when the laser drawing of the predetermined pattern is performed on the surface of the base member applied with the catalyst inactivator, it is thereby possible to form the catalyst inactivator-remaining portion in which the catalyst inactivator permeates or adsorbs to remain and the catalyst inactivator-removed portion which has the predetermined pattern. Note that the surface layer portion of the base member surface may evaporate and disappear together with the catalyst inactivator at the heated portion depending on, for example, the types of the base member and the laser and the laser power. Further, the phrase "removal of the catalyst inactivator" includes not only the complete disappearance of the catalyst inactivator but also the decrease in the amount of the catalyst inactivator to such an extent that no influence is exerted on the progress of the electroless plating treatment to be performed in the aftertreatment step. Even when a minute amount of the catalyst inactivator remains, if no influence is exerted on the electroless plating treatment to be performed in the aftertreatment step, then the function to inhibit the plating reaction disappears. Further, in this embodiment, the situation, in which the catalyst inactivator existing at the heated portion is denatured or modified in quality and the catalyst inactivator does not function as the catalyst inactivator, is also included in the "removal of the catalyst inactivator". This situation is exemplified, for example, by such a situation that the catalyst inactivator cannot function as the catalyst inactivator on account of the chemical change such as the oxidation or the like. In this case, the catalyst inactivator existing at the heated portion does not disappear completely, but any denatured matter (modified matter) remains. The denatured matter loses the ability to inactivate the catalyst. Therefore, the portion, at which the denatured matter of the catalyst inactivator remains, also provides the function which is the same as or equivalent to that of the portion at which the catalyst inactivator disappears.

Subsequently, the electroless plating catalyst is retained on the surface of the base member irradiated with the laser beam (Step S3 shown in Fig. 1). Any arbitrary catalyst can be used as the electroless plating catalyst, provided that the catalyst has the ability of the electroless plating catalyst. However, it is possible to use, for example, metal fine particles, metal complexes, and metal alkoxides of, for example, Pd, Ni, Pt, and Cu. Especially, it is preferable to use the electroless plating catalyst containing Pd which has the high catalytic activity.

The method for allowing the base member surface to retain the electroless plating catalyst is not specifically limited. The electroless plating catalyst may be applied to the surface of the base member, for example, by preparing a catalyst solution in which the electroless plating catalyst is dissolved or dispersed in a solvent, and applying the catalyst solution to the base member or immersing the base member in the catalyst solution. In view of the uniformity or homogeneity of the application of the catalyst, it is preferable to use the method in which the base member is immersed in the catalyst solution.

The solvent, which is used for the catalyst solution, is not specifically limited, provided that the catalyst can be dissolved or dispersed in the solvent. However, for example, it is possible to use water, alcohol such as methanol, ethanol, propyl alcohol, isopropyl alcohol, and butanol, and hydrocarbon such as hexane and heptane. As for the hydrocarbon, it is also allowable to use, for example, a commercially available high boiling point solvent (Isopar (product name), produced by Exxon Mobil Corporation). As for the electroless plating catalyst to be used for the catalyst solution, it is preferable to use a palladium complex in view of the high plating catalytic activity. Specifically, it is possible to use, for example, sodium tetrachloropalladate, potassium tetrachloropalladate, palladium acetate, palladium chloride, acetylacetonatopalladium (II), and hexafluoroacetylacetonatopalladium (II) metal complex. The blending amount (catalyst concentration) of the electroless plating catalyst in the catalyst solution can be, for example, 0.01% by weight to 5% by weight.

Another method for applying the electroless plating catalyst to the base member surface is exemplified by a general purpose method in which a commercially available electroless plating catalyst solution is used, including, for example, a sensitizer-activator method and a catalyzer-accelerator method. In the sensitizer-activator method, the surface of the base member is firstly treated, for example, with a solution containing Sn²⁺ (sensitizer treatment) in order that the electroless plating catalyst easily adsorbs. Subsequently, the base member is immersed in a solution containing the electroless plating catalyst (for example, Pd²⁺) (activator treatment). In the catalyzer-accelerator method, the base member is firstly immersed in a solution containing the electroless plating catalyst (for example, a palladium colloid solution obtained by mixing Sn²⁺ and Pd²⁺) (catalyzer treatment). Subsequently, the base member is immersed, for example, in a hydrochloric acid solution to deposit the metal of the plating catalyst on the surface of the base member (accelerator treatment).

Subsequently, the electroless plating solution is brought into contact with the surface of the base member (Step S4 shown in Fig. 1). Accordingly, the electroless plating film can be formed at the heated portion of the base member surface, and it is possible to produce the plated part in which the plating film is selectively formed. An arbitrary general purpose electroless plating solution can be used as the electroless plating solution depending on the object. However, in view of the fact that the catalytic activity is high and the solution is stable, it is preferable to use an electroless nickel phosphorus plating solution.

As described above, in this embodiment, the catalyst inactivator remaining portion in which the catalyst inactivator permeates or adsorbs and the catalyst inactivator remains, and the catalyst inactivator removed portion having the predetermined pattern in which the catalyst inactivator is removed by the heating are exist on the molded product surface. Then, the electroless plating catalyst is applied to the molded product surface and the electroless plating solution is brought into contact therewith. Thus, the electroless plating film can be formed at only the catalyst inactivator removed portion having the predetermined pattern. The reason thereof is indefinite. However, it is speculated the electroless plating catalyst is poisoned by being directly reacted with the catalyst inactivator at the catalyst inactivator remaining portion. Otherwise, it is speculated that even if the catalyst inactivator is not directly reacted with the electroless plating catalyst, the catalyst inactivator prevents the electroless plating catalyst from exhibiting the catalytic ability at any stage of the catalyst applying step. For example, when iodine is used as the catalyst inactivator, it is speculated that iodine directly reacts with the metal such as palladium or the like as the electroless plating catalyst to form palladium iodide having no catalytic ability, or palladium is oxidized to form palladium oxide having no catalytic ability. On the other hand, the catalyst inactivator does not exist at the catalyst inactivator removed portion, and hence the electroless plating film is generated. Therefore, in this embodiment, the generation of the plating film is suppressed at portions other than the predetermined pattern and the plating film can be formed only at the predetermined pattern in accordance with the simple and easy production process with respect to the base member of various materials.

An electroless plating film of a different type may be further formed on the electroless plating film explained above, or an electroplating film may be formed thereon by means of the electroplating. When the total thickness of the plating film on the base member is thinned, it is thereby possible to decrease the electric resistance when the plating film having the predetermined pattern is used as an electric circuit. In view of the decrease in the electric resistance of the plating film, the plating film, which is stacked on the electroless plating film, is preferably, for example, an electroless copper plating film, an electroplating copper film, and an electroplating nickel film. Further, the electroplating cannot be performed for an electrically isolated circuit. Therefore, in such a situation, it is preferable that the total thickness of the plating film on the base member is thickened by means of the electroless plating. Further, in order to improve the solder wettability of the plating film pattern so that it is possible to respond to the solder reflow, it is also appropriate that a plating film of tin, gold, silver or the like is formed on the outermost surface of the plating film pattern.

The production method of this embodiment may further include a catalyst inactivator removing step of removing the catalyst inactivator from the base member. Note that the phrase "removal of the catalyst inactivator" in the catalyst inactivator removing step means the removal of the catalyst inactivator from the base member, and the phrase does not include such a situation that the catalyst inactivator is denatured or modified (subjected to the quality change) and the catalyst inactivator remains in the base member. Further, the phrase "removal of the catalyst inactivator" includes not only the complete removal of the catalyst inactivator but also the decrease in the amount of the catalyst inactivator.

An explanation will be made below about the step of removing the catalyst inactivator when iodine is used as the catalyst inactivator. In this embodiment, it is preferable that iodine is removed from the base member after the step of allowing the surface of the base member to retain the electroless plating catalyst (Step S3 shown in Fig. 1) or after the step of forming the electroless plating film (Step 4 shown in Fig. 1), for the following reason. That is, iodine easily reacts with the metal, and it is feared the plating film may be corroded if iodine remains in the base member.

The method for removing iodine from the base member is exemplified by a method in which iodine is eluted and removed by washing the base member with a washing solution and a method in which iodine is sublimed and removed by heating or pressure-reducing the atmosphere around the base member. The washing solution, which is used for the washing of iodine, is not specifically limited provided that iodine is dissolved therein and the base member is not modified in quality. It is preferable to use, for example, water, alcohol, and a mixture thereof. Alcohol is exemplified, for example, by methanol, ethanol, propyl alcohol, isopropyl alcohol, and butanol. The washing solution may contain iodide ion in order to enhance the solubility of iodine, and/or the washing solution may contain a surfactant in order to raise the affinity for the base member.

Further, it is more preferable to use such a method for removing iodine that a reducing treatment is performed to reduce at least a part of iodine contained in the base member so that an iodine compound containing iodide ion and cation is produced, and the produced iodine compound is removed from the base member. When iodine is converted into iodide ion, then the solubility in the washing solution such as water or the like is raised, and iodine is easily removed from the base member. Further, the reactivity of iodide ion to react with the metal is low as compared with iodine. Therefore, even if iodide ion remains in the base member, it is hardly feared that the metal may be corroded.

An ordinary reducing agent can be used for the reduction of iodine contained in the base member. For example, there are exemplified sodium borohydride, aldehydes such as formaldehyde, acetaldehyde and the like, sugars such as glucose and the like, sodium thiosulfate, and sodium sulfite. For example, in the case of the reaction with sodium thiosulfate, the base member is immersed in a sodium thiosulfate solution, and thus the iodine molecules (I₂) are reduced as shown in the following chemical reaction formula (1) to provide a state in which the oxidation number is -1 (minus 1) (NaI).

I₂ + 2Na₂S₂O₃ → Na₂S₄O₆ + 2NaI (1)

Further, the reduction of iodine contained in the base member can be also performed by allowing the reducing agent to be contained in the catalyst solution described above. Further, iodine contained in the base member may be reduced by the reducing agent contained in the electroless plating solution or hydrogen produced during the electroless plating.

After the reducing treatment, iodine may be removed from the base member by washing the base member with the washing solution described above. In this case, iodine is converted into the iodine compound which is dissolved in the washing solution such as water or the like and which can be removed from the base member with ease.

When the catalyst inactivator other than iodine is used, the catalyst inactivator may be also removed in the same manner as in the removal of iodine after the step of allowing the surface of the base member to retain the electroless plating catalyst (Step S3 shown in Fig. 1) or after the step of forming the electroless plating film (Step 4 shown in Fig. 1). In particular, when the catalyst inactivator is an ionic compound and the plating film is used as an electric wiring pattern, then it is preferable to remove the catalyst inactivator, because it is feared that the insulation performance may be deteriorated between the wirings. As for the method for removing the catalyst inactivator, it is preferable to use a method in which the base member is washed by using a solvent for dissolving the catalyst inactivator. For example, when triphenylantimony dichloride is used as the catalyst inactivator, then triphenylantimony dichloride is insoluble in water, but triphenylantimony dichloride is soluble in an organic solvent such as methyl ethyl ketone or the like. On this account, triphenylantimony dichloride is not detached or eliminated from the base member surface during the plating step. However, triphenylantimony dichloride can be removed from the base member surface by immersing the base member in methyl ethyl ketone after the plating step and sufficiently washing the base member.

In the production method of this embodiment explained above, the plating film of the predetermined pattern may have conductivity. In this case, the plating film of the predetermined pattern functions, for example, as a wiring pattern or an electric circuit, and the plated part having the plating film of the predetermined pattern functions as an electronic part (electronic component). Further, the plating film of the predetermined pattern may be formed in a planar form on only one surface of the base member. Alternatively, the plating film of the predetermined pattern may be formed three-dimensionally over a plurality of surfaces of the base member or along a surface of a three-dimensional shape including, for example, a spherical surface. When the plating film of the predetermined pattern is formed three-dimensionally over the plurality of surfaces of the base member or along the surface of the three-dimensional shape including, for example, the spherical surface, and the plating film of the predetermined pattern has the conductivity, then the plating film of the predetermined pattern functions as a three-dimensional electric circuit, and the plated part having the plating film of the predetermined pattern as described above functions as a three-dimensional circuit formed part (MID).

Note that according to the invention, the application of the catalyst inactivator to the base member surface (Step S1 shown in Fig. 1), the heating or the light irradiation of the surface of the base member (Step S2 shown in Fig. 1), and the application of the electro less plating catalyst to the base member surface (Step S3 shown in Fig. 1) are carried out in this order. The inactivation of the catalytic activity, which would be otherwise caused, for example, by the air oxidation, can be avoided by applying the catalyst immediately before the plating step. Therefore, the foregoing steps are preferably carried out in this order. However, it is not necessarily indispensable to carry out the foregoing steps in this order. For example, the steps may be carried out in an order of the application of the electroless plating catalyst to the base member surface (Step S3 shown in Fig. 1), the application of the catalyst inactivator (Step S1 shown in Fig. 1), and the heating or the light irradiation of the surface of the base member (Step S2 shown in Fig. 1). Alternatively, the steps may be carried out in an order of the application of the catalyst inactivator to the base member surface (Step S1 shown in Fig. 1), the application of the electroless plating catalyst (Step S3 shown in Fig. 1), and the heating or the light irradiation of the surface of the base member (Step S2 shown in Fig. 1).

### [Second embodiment] (not according to the invention).

An explanation will be made in accordance with a flow chart shown in Fig. 2 about a method for producing a plated part in which a plating film having a predetermined pattern is formed on a base member. In this embodiment, a molded product containing the electroless plating catalyst is used as the base member. The molded product already contains the electroless plating catalyst. Therefore, in this embodiment, it is possible to omit the step of applying the electroless plating catalyst to the surface of the base member (Step S3 shown in Fig. 1) performed in the first embodiment. In this embodiment, the surface of the base member can be allowed to retain the electroless plating catalyst by molding the molded product containing the electroless plating catalyst (Step S 11 shown in Fig. 2).

At first, an explanation will be made about a method for molding the molded product containing the electroless plating catalyst (Step S11 shown in Fig. 2). The method for molding the molded product containing the electroless plating catalyst is not specifically limited. However, the molding can be performed in accordance with a method disclosed in International Publication No. 2013/129659. For example, a first resin pellet containing a block copolymer having a hydrophilic segment (hereinafter appropriately referred to as "block copolymer") and the electroless plating catalyst may be produced, and the molded product may be molded by using a thermoplastic resin (second resin pellet) together with the first resin pellet. The block copolymer has such a tendency that the block copolymer moves toward the molded product surface while accompanying the electroless plating catalyst during the molding process or after the molding of the molded product, and the block copolymer segregates in the vicinity of the surface of the molded product together with the electroless plating catalyst. Accordingly, the neighborhood of the surface of the molded product is made hydrophilic by the block copolymer. Further, the concentration of the electroless plating catalyst is raised, and the plating reactivity of the molded product is improved.

In the method for producing the molded product by using the first and second resin pellets as described above, the first resin pellet is the master batch, and the second resin pellet corresponds to the base resin to which the master batch is blended. The master batch is the resin pellet which contains the functional materials such as a dye, a pigment, other additives and the like at high concentrations. The master batch is mixed with the base resin which contains no functional material, and the master batch is molded together with the base resin. When the master batch is used, the handling performance of the material is easily achieved, and the weighing accuracy is improved as well, as compared with a case in which the functional materials are directly added to the base resin followed by being molded.

The block copolymer, which includes the hydrophilic segment contained by the first resin pellet, has the hydrophilic segment, and the block copolymer further has another segment (hereinafter appropriately referred to as "another segment") which is different from the hydrophilic segment. An anionic segment, a cationic segment, and a nonionic segment can be used for the hydrophilic segment. The anionic segment is exemplified by those based on polystyrene sulfonic acid, the cationic segment is exemplified by those based on quaternary ammonium salt group-containing acrylate polymer, and the nonionic segment is exemplified by those based on polyether ester amide, those based on polyethylene oxide - epichlorohydrin, and those based on polyether ester. In view of the easiness to secure the heat resistance of the molded product, the hydrophilic segment is preferably the nonionic segment having the polyether structure. The polyether structure includes, for example, oxyalkylene group such as polyoxyethylene group, polyoxypropylene group, polyoxytrimethylene group, polyoxytetramethylene group and the like, polyether diol, polyether diamine, and denatured substances thereof, as well as polyether-containing hydrophilic polymer. Especially, it is preferable to use polyethylene oxide.

The other segments of the block copolymer are arbitrary provided that the other segments are more hydrophobic than the hydrophilic segment, for which it is possible to use, for example, nylon and polyolefin.

Any commercially available product may be used for the block copolymer. For example, it is possible to use Pelestat (trade name), Pelectron (trade name) and the like produced by Sanyo Chemical Industries, Ltd. For example, Pelestat NC6321 and Pelestat NC1251 produced by Sanyo Chemical Industries, Ltd. are block copolymers in each of which polyether of hydrophilic segment and nylon of another segment are copolymerized by means of ester bond.

Those which are the same as or equivalent to those of the first embodiment can be used as the electroless plating catalyst contained by the first resin pellet. The content of the electroless plating catalyst in the first resin pellet is preferably not less than 0.1 ppm by weight and more preferably not less than 1 ppm by weight in view of the reactivity of the electroless plating. Further, the upper limit is determined, for example, by the saturated solubility of the electroless plating catalyst in pressurized carbon dioxide, for example, in a method for producing the molded product described later on. Therefore, the upper limit depends on the type of the electroless plating catalyst.

The method for producing the first resin pellet is arbitrary. However, the first resin pellet can be produced in accordance with a method disclosed in International Publication No. 2013/129659. For example, pressurized carbon dioxide, in which the electroless plating catalyst is dissolved, may be mixed with the plasticized and melted block copolymer to perform the extrusion molding by using an extrusion molding machine, and an extrusion molded product may be pulverized to obtain the first resin pellet. Pressurized carbon dioxide is the solvent for the electroless plating catalyst, and pressurized carbon dioxide also acts as a plasticizer for the block copolymer, which facilitates the uniform dispersion of the electroless plating catalyst in the block copolymer. Therefore, when the plated part is produced by using the first resin pellet which is produced by using the electroless plating catalyst, a plating film, which is uniform (homogeneous) and which has a high quality, is obtained. It is also possible to produce the first resin pellet without using pressurized carbon dioxide. However, it is preferable to use pressurized carbon dioxide for the reason described above.

Further, the first resin pellet may be also produced in accordance with a method in which pressurized carbon dioxide, in which the electroless plating catalyst is dissolved, is brought into contact with the pellet-shaped block copolymer (raw material pellet) in a high pressure vessel. In this case, the electroless plating catalyst permeates into the raw material pellet together with pressurized carbon dioxide, and it is possible to produce the first resin pellet containing the electroless plating catalyst.

Subsequently, the second resin pellet is plasticized and melted together with the produced first resin pellet to mold the molded product containing the electroless plating catalyst in accordance with a general purpose molding method by using a molding machine such as a general purpose injection molding machine, an extrusion molding machine or the like. The thermoplastic resin, which is exemplified as the material to be used for the base member of the first embodiment, can be used as the material of the second resin pellet. It is preferable that the second resin pellet does not contain the block copolymer in view of the heat resistance. Further, it is unnecessary for the second resin pellet to contain the electroless plating catalyst, because the first resin pellet contains the electroless plating catalyst. It is preferable that the electroless plating catalyst is not contained in the second resin pellet in view of the reduction of the cost.

Subsequently, the application of the catalyst inactivator (Step S1 shown in Fig. 2), the heating of the base member by means of, for example, the laser drawing (Step S2 shown in Fig. 2), the electroless plating (Step S3 shown in Fig. 2), and the removal of the catalyst inactivator (iodine) from the base member are carried out in this order for the molded product (base member) containing the electroless plating catalyst in accordance with a method which is the same as or equivalent to that of the first embodiment. Accordingly, the electroless plating film can be formed at only the heated portion of the base member surface.

In this embodiment, the mechanism, in accordance with which the electroless plating film can be formed at only the heated portion of the base member surface, is speculated as follows. The electroless plating catalyst disposed on the base member surface is poisoned by applying the catalyst inactivator to the molded product (base member) containing the electroless plating catalyst (Step S1 shown in Fig. 2). However, in this embodiment, the electroless plating catalyst is not applied from the outside, but the electroless plating catalyst is kneaded into the inside of the molded product. Therefore, the electroless plating catalyst also exists at the inside of the base member at the depth deeper than the permeation depth of the catalyst inactivator. The electroless plating catalyst, which is disposed at the inside and which is not brought into contact with the catalyst inactivator, is not poisoned. When the laser beam is radiated onto the base member in the state in which the electroless plating catalyst disposed at the surface layer portion is poisoned (Step S2 shown in Fig. 2), then the surface is roughened in accordance with the evaporation of the thermoplastic resin disposed at the laser beam-irradiated portion, and the electroless plating catalyst, which exists at the inside of the molded product and which is not poisoned, is exposed on the base member surface. Further, the base member surface is roughened, and thus the electroless plating solution easily permeates. The permeated electroless plating solution is brought into contact with the electroless plating catalyst which is disposed at the inside of the base member and which is not poisoned, and the plating film grows from the inside. On the other hand, the generation of the electroless plating film is suppressed on account of the presence of the catalyst inactivator at the portions other than the laser beam-irradiated portion. In this way, also in this embodiment, the generation of the plating film can be suppressed at the portions other than the predetermined pattern and the plating film can be formed at only the predetermined pattern in accordance with the simple and easy production process.

### [Third embodiment]

In this embodiment, a base member is used, which has an area provided with a predetermined first pattern formed by protrusions and/or recesses extending on a surface. Then, an electroless plating film is formed at the protrusions and/or recesses which form the first pattern. An explanation will be made about a method for producing a plated part of this embodiment in accordance with the flow chart shown in Fig. 1 in the same manner as the first embodiment.

At first, the catalyst inactivator is applied to the surface of the base member having the area in which the predetermined first pattern is formed by the extending protrusions and/or recesses (Step S1 shown in Fig. 1).

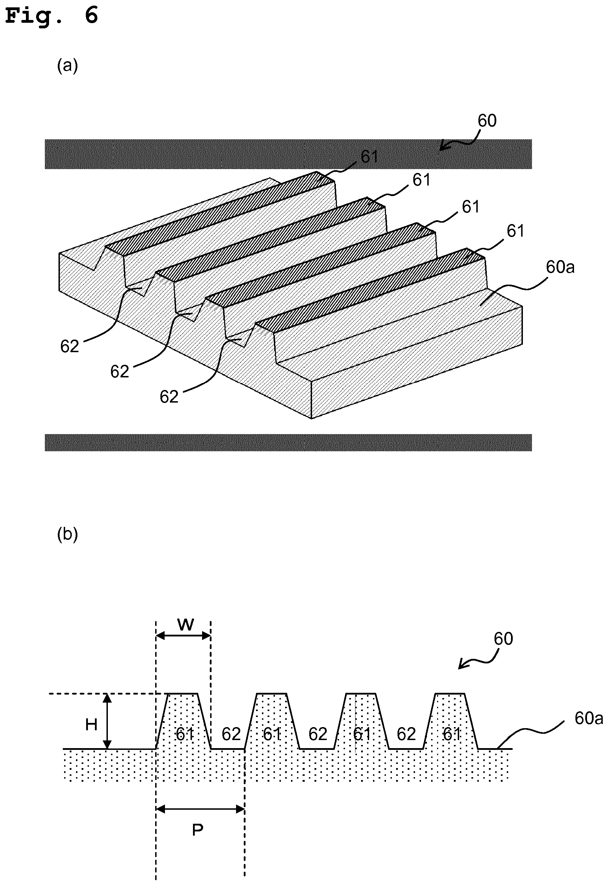

The base member 60 of this embodiment shown in Figs. 6(a) and 6(b) is a plate-shaped member. A plurality of protrusions 61, which extend in a straight form, are arranged substantially in parallel on one surface 60a, and recesses 62 are formed between the mutually adjoining protrusions 61. In this way, in this embodiment, the predetermined first pattern is formed by the plurality of protrusions 61 on the entire surface of the surface 60a of the base member 60. That is, in this embodiment, the entire surface of the surface 60a of the base member 60 is the area in which the first pattern is formed.

Materials, which are the same as or equivalent to those of the first embodiment, can be used as the materials for the base member. The base member may be a commercially available product. Alternatively, the base member may be produced from a commercially available material by means of the molding or the like. The protrusions and recesses on the base member surface may be formed simultaneously during the molding. Alternatively, the protrusions and recesses may be formed by means of, for example, the cutting processing, the etching, or the hot pressing (thermal pressing) after the molding.

The cross-sectional shape of the protrusion 61 extending on the surface 60a is not specifically limited. However, it is preferable to adopt a shape which is more tapered at positions separated farther from the surface 60a so that a mold is easily pulled out when the protrusions are formed by using the mold. There are exemplified, for example, semicircles, triangles, and trapezoids. In this embodiment, the cross-sectional shape of the protrusion 61 is trapezoidal. Note that that the cross-sectional shape of the protrusion 61 is the shape of the cross section of the protrusion 61 which is perpendicular to the surface 60a and which is perpendicular to the extending direction of the protrusion 60.

In view of the prevention of the diffusion of the heat to the recesses 62 during the heating step for the protrusions 61 described later on, the width W of the protrusion 61 is preferably 0.1 mm to 100 mm and more preferably 2 mm to 10 mm, the height H is preferably 0.05 mm to 10 mm and more preferably 0.1 mm to 5 mm, and the pitch P is preferably 0.5 mm to 100 mm and more preferably 1 mm to 10 mm. Further, in view of the uniform heating of the protrusions 61, it is preferable that the heights H of the protrusions 61 are approximately constant.

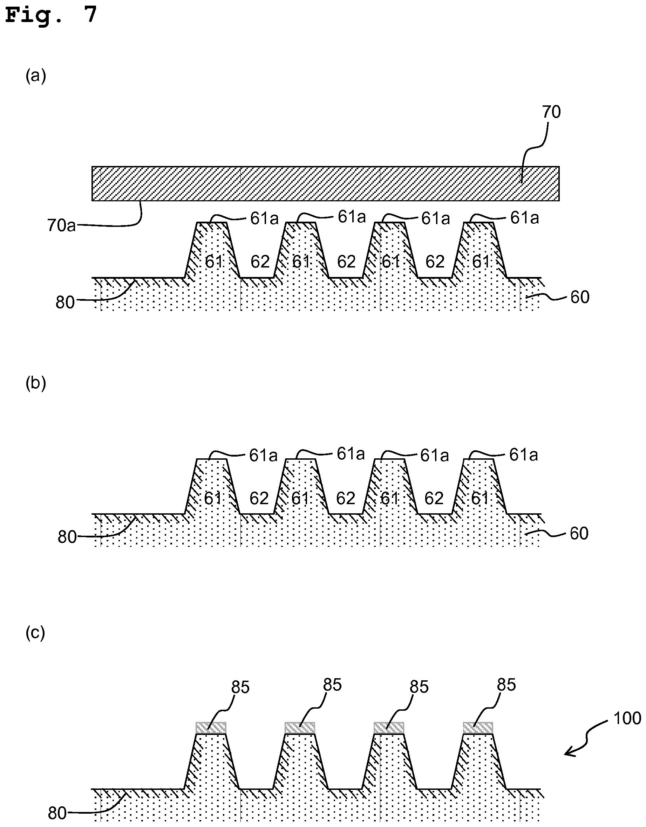

The substance, which is the same as or equivalent to that of the first embodiment, can be used for the catalyst inactivator. Further, the catalyst inactivator can be applied to the base member surface in accordance with a method which is the same as or equivalent to that of the first embodiment. The catalyst inactivator is applied to at least the area in which the predetermined first pattern is formed. As shown in Fig. 7(a), it is speculated that the catalyst inactivator 80, which is applied to the base member 60, permeates into the portion disposed in the vicinity of the surface of the base member 60 (surface layer portion), or the catalyst inactivator 80 adsorbs to the surface of the base member 60.

Subsequently, as shown in Fig. 7(a), the top portions 61a of the protrusions 61 for forming the first pattern are heated by using a heating plate 70 (Step S2 shown in Fig. 1). In this procedure, the heating plate 70 may be directly brought into contact with the top portions 61 to perform the hot pressing. Alternatively, if the top portions 61a can be sufficiently heated by allowing the heating plate 70 to approach the top portions 61, it is also allowable that the heating plate 70 is not directly brought into contact with the top portions 61a. A cheap metal plate of, for example, stainless steel, aluminum or the like can be used as the heating plate 70. The heating temperature and the heating time for heating the protrusions 61 of the base member and the press pressure provided when the pressing is performed can be appropriately determined depending on, for example, the heat resistant such as the melting point or the like of the base member and the type of the catalyst inactivator. For example, the heating temperature (temperature of the heating plate) can be 100°C to 350°C, the heating time can be 0.1 second to 120 seconds, and the press pressure can be 1kgf/cm² to 1000 kgf/cm².

As shown in Fig. 7(b), the catalyst inactivator 80, which exists at the top portions 61a of the heated protrusions 61, is removed from the surfaces of the top portions 61a by being evaporated or sublimed. Note that the surface layer portions of the top portions 61a may be evaporated to disappear together with the catalyst inactivator depending on the base member and the heating condition. In this way, in this embodiment, catalyst inactivator removed portions of the first pattern including the top portions 61a are formed on the surface of the base member 60 by heating the top portions 61a of the protrusions 61. Then, areas other than the top portions 61a are catalyst inactivator remaining portions in which the catalyst inactivator permeates or adsorbs and the catalyst inactivator remains.

Subsequently, the surface of the base member 60 is allowed to retain the electroless plating catalyst in accordance with a method which is the same as or equivalent to that of the first embodiment (Step S3 shown in Fig. 1), and the electroless plating solution is brought into contact therewith (Step S4 shown in Fig. 1). Accordingly, the electroless plating film 85 is formed at only the heated top portions 61a, and it is possible to produce a plated part 100 on which the plating film is selectively formed. Further, in this embodiment, an electroless plating film of a different type may be formed on the electroless plating film, if necessary, in the same manner as the first embodiment. Further, an electroplating film may be formed by the electroplating. Further, the catalyst inactivator may be removed from the base member after the step of allowing the surface of the base member to retain the electroless plating catalyst (Step S3 shown in Fig. 1) or after the step of forming the electroless plating film (Step S4 shown in Fig. 1) in the same manner as the first embodiment.

In this embodiment, the generation of the electroless plating film at the portion other than the first pattern can be suppressed, and the electroless plating film can be formed at only the first pattern in accordance with the simple and easy production process in the same manner as the first embodiment. Further, in this embodiment, the portions, on which the plating film is formed, are the protrusions 61. Thus, it is possible to suppress the diffusion of the heat to the portions other than the protrusions 61, and it is possible to form the distinct plating film pattern. Further, when the plating film of this embodiment is utilized as a wiring pattern or an electric circuit, the plating film 85 to serve as the wiring is formed on the top portions 61a of the protrusions 61. Therefore, the effective distance between the wirings, which is provided between the adjoining wirings, is lengthened, and the insulating performance is improved between the wirings. Accordingly, it is possible to raise the wiring density of the electronic part. Further, in this embodiment, the base member 60 is heated by using the heating plate which can be formed, for example, of cheap stainless steel, aluminum or the like without using the laser beam. Therefore, it is possible to produce large-sized MID cheaply in a short period of time. Any heating plate (press mold), which conforms to the product shape, can be conveniently manufactured with aluminum which can be subjected to the processing with ease. Further, in this embodiment, the heating portions are the protrusions 61. Thus, it is possible to use the heating plate 70 in which the surface 70a for making contact with the protrusions 61 is the flat plate. That is, it is unnecessary to prepare the heating plate for every pattern of a desired plating film, and it is possible to reduce the production cost.

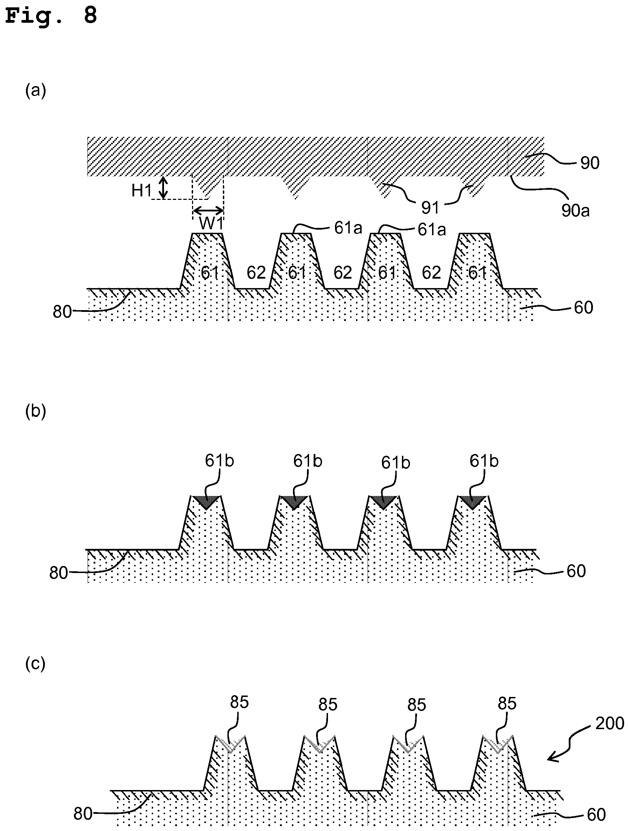

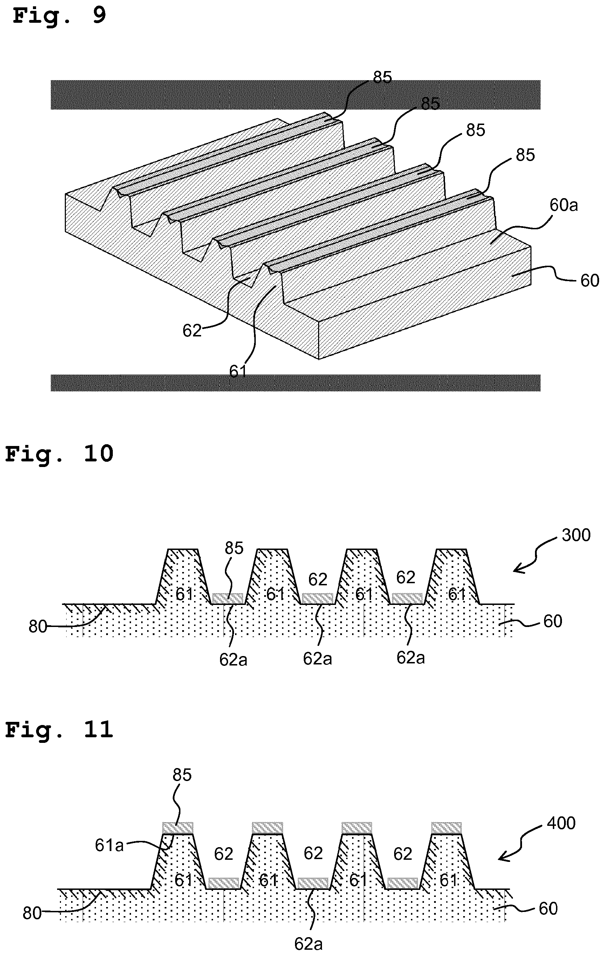

Next, an explanation will be made about a first modified embodiment of the embodiment of the present invention as shown in Figs. 8(a) to 8(c) and Fig. 9. In the embodiment of the present invention described above, the heating plate 70, in which the surface 70a to be brought into contact with the protrusions 60 is the flat surface, is used (see Fig. 7(a)). However, the embodiment of the present invention is not limited thereto. For example, the base member 60 may be thermally pressed (hot pressed) by using a heating plate 90 as shown in Fig. 8(a). The heating plate 90 has protruding portions 91 extending on a surface 90a to be brought into contact with the base member 60. The protruding portions 91 form a second pattern corresponding to the first pattern of the base member 60 on the surface 90a. In this modified embodiment, in the heating step of heating the base member (Step S2 shown in Fig. 1), the second pattern, which is formed by the protruding portions 91 of the heating plate 90, is brought into contact with the first pattern which is formed by the protrusions 61 of the base member 60, and the base member 60 is thermally pressed by the heating plate 90. Accordingly, as shown in Fig. 8(b), depressions 61b, which correspond to the protruding portions 91, are formed at the top portions 61a of the protrusions 61. After that, the surface of the base member 60 is allowed to retain the electroless plating catalyst in accordance with a method which is the same as or equivalent to that of the first embodiment (Step S3 shown in Fig. 1), and the electroless plating solution is brought into contact therewith (Step S4 shown in Fig. 1). Accordingly, in this modified embodiment, as shown in Fig. 8(c) and Fig. 9, electroless plating films 85 are formed in the depressions 61b, and it is possible to produce a plated part 200 in which the plating films are selectively formed. The electroless plating film 85 is formed in the depression 61b, and thus the adhesion strength of the electroless plating film 85 with respect to the base member 60 is improved in this modified embodiment. The protruding portions 91 of the heating plate 90 form the depressions 61b at the protrusions 61 of the base member 60. Therefore, it is preferable that the width W1 and the height H1 of the protruding portion 91 are smaller than the width W and the height H of the protrusion 61 respectively. In this embodiment, the base member 60 is heated by the protruding portions 91 which are smaller than the protrusions 61. Therefore, it is possible to suppress the diffusion of the heat to the surroundings of the protrusions 61.

Next, an explanation will be made about a second modified embodiment of the embodiment of the present invention shown in Fig. 10. In the embodiment of the present invention described above, the first pattern is formed by the protrusions 60, and the electroless plating films 85 are formed at the protrusions 61. However, the embodiment of the present invention is not limited thereto. For example, as shown in Fig. 10, the first pattern may be formed by recesses 62, and an electroless plating film 85 may be provided at the bottom 62a of the recess 62. In the embodiment of the present invention described above, the catalyst inactivator is applied to the base member 60 (Step S1 shown in Fig. 1), and then the top portions 61a of the protrusions 61 are heated by using the heated heating plate 70 to remove the catalyst inactivator from the heated portions (Step S2 shown in Fig. 1). On the other hand, in this modified embodiment, the catalyst inactivator is applied to the base member 60 in accordance with a method which is the same as or equivalent to that of the embodiment of the present invention described above (Step S1 shown in Fig. 1), and then the laser beam is radiated onto the bottoms 62a of the recesses 62 to thereby remove the catalyst inactivator from the laser beam-irradiated portions (Step S2 shown in Fig. 1). After that, the surface of the base member 60 is allowed to retain the electroless plating catalyst in accordance with a method which is the same as or equivalent to that of the embodiment of the present invention described above (Step S3 shown in Fig. 1), and the electroless plating solution is brought into contact therewith (Step S4 shown in Fig. 1). Accordingly, the electroless plating film 85 is formed at only the bottom 62a irradiated with the laser beam, and it is possible to produce a plated part 300. In this modified embodiment, the laser beam irradiation is used. Therefore, the diffusion of the heat to the surroundings around the heated portions is suppressed as compared with the case in which the heating plate is used. On this account, the sizes of the protrusions and recesses are decreased, and the wiring density of the electronic part is further raised. For example, when the laser beam is used, the width W of the protrusion 61 shown in Fig. 6(b) is preferably 10 µm to 1000 µm and more preferably 50 µm to 500 µm, the height H is preferably 10 µm to 200 µm and more preferably 5 µm to 100 µm, and the pitch P is preferably 10 µm to 1000 µm and more preferably 30 µm to 100 µm.

Further, an explanation will be made about a third modified embodiment of the embodiment of the present invention shown in Fig. 11. In this modified embodiment, as shown in Fig. 11, the first pattern is formed by protrusions 61 and recesses 62, and the electroless plating films 85 are formed at both of the top portion 61a of the protrusion 61 and the bottom 62a of the recess 62. At first, the catalyst inactivator is applied to the base member 60 in accordance with a method which is the same as or equivalent to that of the embodiment of the present invention described above (Step S1 shown in Fig. 1). After that, the catalyst inactivator, which exists at both of the top portion 61a of the protrusion 61 and the bottom 62a of the recess 62, is removed. As for the method for removing the catalyst inactivator, for example, the laser beam may be radiated onto both of the top portion 61a and the bottom 62a. As another method, the heating plate may be brought into contact with the top portion 61a, and the laser beam may be radiated onto the bottom 62a (Step S2 shown in Fig. 1). After that, the surface of the base member 60 is allowed to retain the electroless plating catalyst in accordance with a method which is the same as or equivalent to that of the embodiment of the present invention described above (Step S3 shown in Fig. 1), and the electroless plating solution is brought into contact therewith (Step S4 shown in Fig. 1). Accordingly, the electroless plating films 85 are formed at both of the top portions 61a and the bottoms 62a, and it is possible to produce a plated part 400. In this modified embodiment, the plating films are formed at both of the protrusions 61 and the recesses 62, and thus the wiring density of the electronic part is further raised.

### EXAMPLES

The present invention will be specifically explained below with reference to Examples and Comparative Examples. However, the present invention is not limited to Examples and Comparative Examples described below.

### [Example 1]

In Example 1, a resin molded product was molded as the base member. Then, the application of the catalyst inactivator onto the molded resin molded product, the heating of the resin molded product by means of the laser drawing, the application of the electroless plating catalyst, the electroless plating, and the removal of the catalyst inactivator were performed in this order to produce a plated part in which the plating film was selectively formed. Note that iodine was used as the catalyst inactivator.

### (1) Molding of resin molded product

Nylon 6T (PA6T) (Amodel (trade name) AS-1566HS, black grade, produced by Solvay Advanced Polymers) was molded into a plate-shaped member of 4 cm x 6 cm x 0.2 cm by using a general purpose injection molding machine (J180AD-300H produced by The Japan Steel Works, Ltd.).

### (2) Application of iodine

An iodine solution, which had an iodine concentration of 1.5% by weight and a potassium iodide concentration of 6% by weight and which used a mixture of water and ethanol as a solvent, was prepared in accordance with the following procedure. At first, 18.0 g of potassium iodide (reagent produced by Wako Pure Chemical Industries, Ltd.) was dissolved in 194.5 g of water to prepare an aqueous potassium iodide solution. Subsequently, 4.5 g of iodine (reagent produced by Wako Pure Chemical Industries, Ltd.) was added to the prepared aqueous potassium iodide solution, followed by being completely dissolved by performing agitation. Further, 83.0 g of ethanol (reagent produced by Wako Pure Chemical Industries, Ltd.) was added to obtain the iodine solution.

The prepared iodine solution was introduced into a tall beaker of 300 cc. The resin molded product (base member) was immersed in the iodine solution, followed by being left to stand for 10 minutes at room temperature. After that, the resin molded product was taken out from the iodine solution, and the resin molded product was sufficiently washed with water. After that, water droplets adhered to the base member were removed by means of the air blow.

### (3)Laser drawing

A laser beam was radiated along a predetermined pattern onto the resin molded product applied with iodine by using a laser drawing apparatus (MD-V9929WA produced by Keyence Corporation, YVO₄ laser, wavelength: 1064 nm). The laser drawing was performed at a drawing speed of 500 mm/sec, a frequency of 50 kHz, and a power of 80%. The pattern, which was subjected to the laser drawing in Example 1, was a pattern including a plurality of straight lines having a pitch of 500 µm, a line width of 200 µm, and a length of 4 cm. That is, the pattern had the line and space (L/S) of 200 µm / 300 µm.

### (4) Application of electroless plating catalyst

The resin molded product, for which the laser drawing was performed, was immersed in a catalyst solution, and the electroless plating catalyst was applied to the surface of the resin molded product. At first, 1.5 g of hexafluoroacetylacetonatopalladium (II) (reagent produced by Aldrich) was dissolved in 300 g of hexane (reagent produced by Wako Pure Chemical Industries, Ltd.) to prepare the catalyst solution having a palladium complex concentration (catalyst concentration) of 0.5% by weight.

The prepared catalyst solution was introduced into a tall beaker of 300 cc, and the resin molded product, for which the laser drawing was performed, was immersed in the catalyst solution, followed by being left to stand for 5 minutes at room temperature. After that, the resin molded product was taken out from the catalyst solution, and the resin molded product was sufficiently washed with hexane, ethanol, and water in this order.

### (5) Electroless plating

An electroless nickel-phosphorus plating solution (SE-666 produced by Kanigen) was introduced into a tall beaker of 500 cc, and the resin molded product, to which the electroless plating catalyst was applied, was immersed in the plating solution to perform the electroless plating at 80°C for 15 minutes. After the electroless plating, the resin molded product was taken out from the plating solution, and the resin molded product was sufficiently washed with water. The resin molded product was observed during the electroless plating. As a result, bubbles were generated at only the portion subjected to the laser drawing. It was speculated that the bubbles were hydrogen. According to this fact, it was possible to confirm that the electroless plating reaction was caused at only the portion subjected to the laser drawing.

### (6) Reduction and removal of iodine

Iodine was removed from the resin molded product subjected to the electroless plating in accordance with the following method. At first, 49.5 g of sodium thiosulfate (reagent produced by Wako Pure Chemical Industries, Ltd.) was dissolved in 280 g of water to prepare an aqueous sodium thiosulfate solution having a sodium thiosulfate concentration of 15% by weight. The prepared aqueous sodium thiosulfate solution was introduced into a tall beaker of 300 cc, and the resin molded product, for which the electroless plating was performed, was immersed in the aqueous sodium thiosulfate solution, followed by being left to stand for 10 minutes at room temperature. After that, the resin molded product was taken out from the aqueous sodium thiosulfate solution, and the resin molded product was sufficiently washed with water.

### <Evaluation>

The plated part, which was produced in accordance with the production method as explained above, was visually observed. In the case of the plated part of Example 1, the plating film was formed at only the predetermined pattern for which the laser drawing was performed. Any deposition of the plating film was not observed at the portions other than the predetermined pattern. It is speculated that the electroless plating film was generated at the portion of the predetermined pattern because iodine was removed by the laser beam irradiation and iodine was not present, while the generation of the electroless plating film was suppressed on account of the presence of iodine at the portions other than the predetermined pattern.

Subsequently, the electric resistance was measured for the portion formed with the plating film (predetermined pattern portion). As for the measuring method, a method was used, in which terminals of a tester were held against one end and the other end of the plating film having a shape of one straight line to measure the electric resistance between the terminals. As a result, the electric resistance was 10 **Ω** which was a low value. It was possible to confirm that the predetermined pattern portion had the conductivity.

### [Example 2]

In Example 2, a part of the base member was heated by performing the hot press by pressing a stainless steel plate having a high temperature against the base member in place of the laser drawing. Further, the electroless plating catalyst was applied to the base member by means of the sensitizer-activator method. Further, the reducing treatment was not performed for iodine. A plated part, in which a plating film was selectively formed, was produced in accordance with a method which was the same as or equivalent to that of Example 1 except for the above.

### (1) Molding of resin molded product and application of iodine

In accordance with a method which was the same as or equivalent to that of Example 1, at first, a resin molded product was molded as the base member, and subsequently, iodine was applied to the resin molded product.

### (2) Heating of base member

At first, a stainless steel plate of 2 cm x 4 cm x 0.5 cm was prepared, which was heated to 150°C. Then, the stainless steel plate at 150°C was pressed against the resin molded product for 1 minute to heat a part of the resin molded product. After that, the resin molded product was left to stand for 10 minutes, and the resin molded product was cooled to room temperature.

### (3) Application of electroless plating catalyst

A sensitivity applying agent (sensitizer, produced by OKUNO CHEMICAL INDUSTRIES CO., LTD.) was introduced into a tall beaker of 300 cc. The resin molded product, which was heated by using the stainless steel plate, was immersed in the sensitivity applying agent, followed by being left to stand for 3 minutes at room temperature. After that, the resin molded product was taken out from the sensitivity applying agent, and the resin molded product was sufficiently washed with water. Subsequently, a catalyzing treatment agent (activator, produced by OKUNO CHEMICAL INDUSTRIES CO., LTD.) was introduced into a tall beaker of 300 cc. The resin molded product was immersed in the catalyzing treatment agent, followed by being left to stand at 30°C for 1 minute. After that, the resin molded product was taken out from the catalyzing treatment agent, and the resin molded product was sufficiently washed with water.

### (4) Electroless plating

The electroless plating was performed for the resin molded product to which the electroless plating catalyst was applied, in accordance with a method which was the same as or equivalent to that of Example 1. The resin molded product was observed during the electroless plating. As a result, bubbles were generated at the heated portion of the resin molded product. It was speculated that the bubbles were hydrogen. According to this fact, it was possible to confirm that the electroless plating reaction occurred at only the heated portion.

### (5) Removal of iodine

Ethanol was introduced into a tall beaker of 300 cc, and the base member was introduced thereinto, followed by being left to stand for 1 hour to wash out iodine contained in the base member.

### <Evaluation>

The plated part, which was produced in accordance with the production method as explained above, was visually observed. In the case of the plated part of Example 2, the plating film was formed at only the heated portion. Any deposition of the plating film was not observed at the portions other than the heated portion. It is speculated that the electroless plating film was generated at the portion of the predetermined pattern because iodine was removed by the heating and iodine was not present, while the generation of the electroless plating film was suppressed on account of the presence of iodine at the portions other than the predetermined pattern.

Subsequently, the electric resistance was measured for the portion formed with the plating film (heated portion). As for the measuring method, a method was used, in which terminals of a tester were held against diagonal apex portions of the rectangular plating film to measure the electric resistance between the terminals. As a result, the electric resistance was 10 **Ω** which was a low value. It was possible to confirm that the portion formed with the plating film had the conductivity.

### [Example 3]

In Example 3, a three-dimensional circuit part (MID) having a three-dimensional shape, in which a plating film having a predetermined pattern was three-dimensionally formed on a spherical surface, was produced as the plated part. At first, a resin molded product having a semispherical shape was molded as the base member. The application of the catalyst inactivator onto the molded resin molded product, the heating of the resin molded product by means of the laser drawing, the application of the electroless plating catalyst, the removal of the catalyst inactivator, and the electroless plating were performed in this order. Note that iodine was used as the catalyst inactivator.

### (1) Molding of resin molded product and application of iodine

At first, a semispherical molded product, which had a diameter of 6 cm, a height of 3 cm, and a wall thickness of 1 mm, was molded by using an injection molding machine and a thermoplastic resin which were the same as or equivalent to those of Example 1. Subsequently, iodine was applied to the resin molded product in accordance with a method which was the same as or equivalent to that of Example 1.

### (2) Laser drawing

The laser drawing was performed with a predetermined pattern on the spherical surface of the resin molded product applied with iodine under a laser drawing condition which was the same as or equivalent to that of Example 1 by using a laser drawing apparatus which was the same as or equivalent to that of Example 1.

### (3) Application of electroless plating catalyst

In Example 3, the electroless plating catalyst was applied to the base member in accordance with the sensitizer-activator method by using the commercially available catalyst solution for the electroless plating in the same manner as Example 2.

### (4) Reduction and removal of iodine

Iodine was removed in accordance with the following method from the resin molded product to which the electroless plating catalyst was applied. At first, 4.0 g of sodium borohydride (reagent produced by Wako Pure Chemical Industries, Ltd.) was dissolved in 800 g of ethanol to prepare a solution of 0.5% by weight of sodium borohydride. The resin molded product, to which the electroless plating catalyst was applied, was immersed in 1000 g of the prepared sodium borohydride solution, followed by being left to stand for 5 minutes at room temperature. After that, the resin molded product was taken out from the sodium borohydride solution, followed by being sufficiently washed with water.

### (5) Electroless plating

An electroless copper plating solution having a high deposition rate (OPC Copper NCA produced by OKUNO CHEMICAL INDUSTRIES CO., LTD.) was introduced into a tall beaker of 2000 cc, and the resin molded product after the iodine reduction treatment was immersed in the plating solution. The electroless plating was performed at 60°C for 1 hour to form a copper plating film having a thickness of 7 µm. After the electroless plating, the resin molded product was taken out from the plating solution, followed by being sufficiently washed with water.

### <Evaluation>

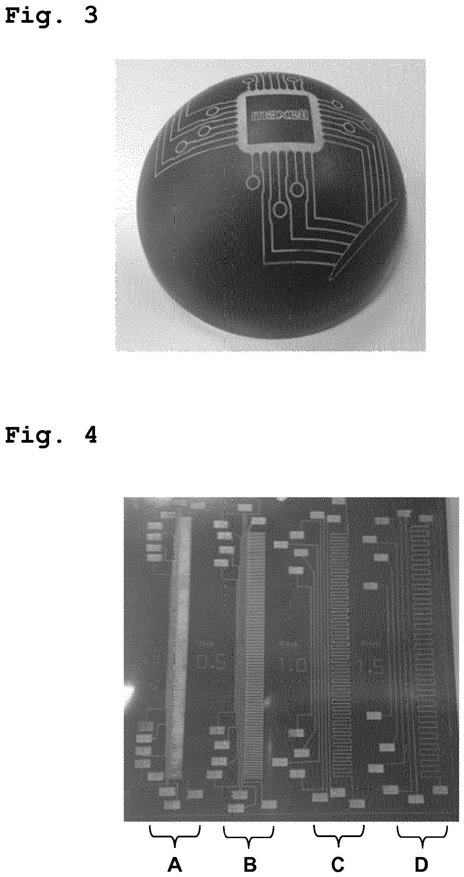

Fig. 3 shows a photograph of the plated part (three-dimensional circuit part, MID) produced in accordance with the production method as explained above. In the case of the plated part produced in Example 3, the plating film was formed at only the predetermined pattern subjected to the laser drawing, and the deposition of the plating film was not found at portions other than the predetermined pattern. It is speculated that the electroless plating film was generated at the predetermined pattern portion because iodine was removed by the irradiation with the laser beam and iodine was not present, while the generation of the electroless plating film was suppressed by the presence of iodine at the portions other than the predetermined pattern.

A heat shock test was performed for the plated part (MID) produced in Example 3, in which the procedure for allowing the plated part (MID) to be left to stand for 1 hour in an environment at 120°C and the procedure for allowing the plated part (MID) to be left to stand for 1 hour in an environment at -40°C were alternately repeated ten times. As a result, any exfoliation of the plating film of the plated part was not caused. According to this result, it was revealed that MID of Example 3 had the high reliability.

### [Example 4]

In Example 4, a part, in which a wiring model pattern is formed by a plating film on a surface, was produced as the plated part. At first, a flat plate-shaped resin molded product was molded as the base member. The application of the catalyst inactivator onto the molded resin molded product, the heating of the resin molded product by the laser drawing, the application of the electroless plating catalyst, and the electroless plating were performed in this order. In Example 4, the removal of the catalyst inactivator was not performed. Note that iodine was used as the catalyst inactivator.

### (1) Molding of resin molded product and application of iodine

At first, an injection molding machine, which was the same as or equivalent to that used in Example 1, was used to mold a flat plate-shaped molded product of 10 cm x 10 cm x 0.2 cm by using, as the thermoplastic resin, aromatic nylon originating from plant (VYLOAMIDE (trade name) produced by TOYOBO CO., LTD.) having a high melting point (310°C). Subsequently, iodine was applied to the resin molded product in accordance with a method which was the same as or equivalent to that of Example 1. Aromatic nylon used in Example 4 is preferred for MID, because the melting point is high, the warpage and the burrs are scarcely formed, and the moldability is excellent.

### (2) Laser drawing

The laser drawing of a predetermined circuit pattern was performed on the resin molded product applied with iodine by using a laser drawing apparatus which was the same as or equivalent to that of Example 1 and under a laser drawing condition which was the same as or equivalent to that of Example 1. Circuit patterns were provided as follows. That is, the circuit patterns had four types of pitches, i.e., pitches of 300 µm, 500 µm, 1.0 mm, and 1.5 mm. The line width in each of the circuit patterns was 200 µm. Therefore, the line-and-spaces (L/S) of the respective circuit patterns were 200 µm/100 µm, 200 µm/300 µm, 200 µm/800 µm, and 200 µm/1300 µm.

### (3) Application of electroless plating catalyst

In Example 4, the electroless plating catalyst was applied to the base member in accordance with the sensitizer-activator method by using a commercially available catalyst solution for the electroless plating in the same manner as Example 2.

### (4) Electroless plating

The electroless plating was performed in accordance with a method which was the same as or equivalent to that of Example 3 by using an electroless copper plating solution in the same manner as Example 3.

### <Evaluation>

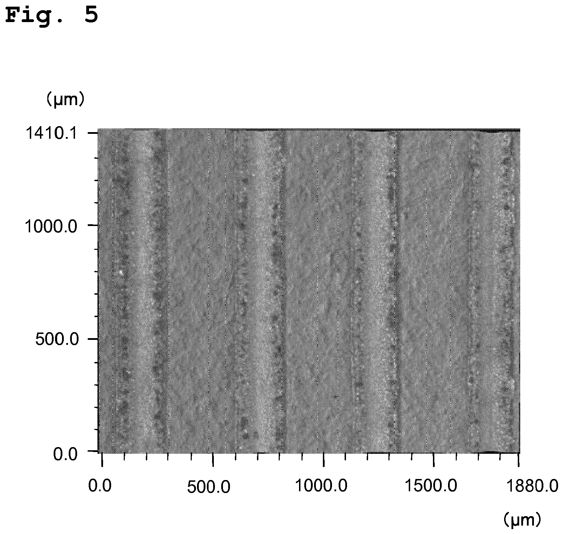

Fig. 4 shows a photograph of the part (plated part) formed with the wiring model pattern produced in accordance with the production method as explained above. The circuit pattern having the pitch of 300 µm was formed in Area A shown in Fig. 4, the circuit pattern having the pitch of 500 µm was formed in Area B, the circuit pattern having the pitch of 1.0 mm was formed in Area C, and the circuit pattern having the pitch of 1.5 mm was formed in Area D. Fig. 5 shows an enlarged photograph of the circuit pattern having the pitch of 500 µm in Area B shown in Fig. 4. As for the plated parts produced in Example 4, the portions, in which the wirings were partially connected to one another, were found here and there in the case of the circuit pattern having the pitch of 300 µm. However, as shown in Fig. 5, any short circuit formation was not found in the wiring, in the case of the circuit pattern having the pitch of not less than 500 µm. According to the result described above, it has been confirmed that the plated part (electronic part), in which the electric circuit is formed, can be produced in accordance with the simple and easy process by using the high-performance (high-functioning) resin material by means of the method of Example 4.

### [Example 5] (not according to the invention)

In Example 5, a molded product containing the electroless plating catalyst was molded as the base member. Therefore, the application of the electroless plating catalyst to the base member was not performed. Further, an electroless plating pretreatment was performed with hydrochloric acid before the electroless plating. A plated part, on which a plating film was selectively formed, was produced in accordance with a method which was the same as or equivalent to that of Example 1 other than the above.

### (1) Molding of molded product containing electroless plating catalyst

### (a) Production of first resin pellet

A pressure resistant vessel of 250 cc was prepared, which had a first piping connected to a liquid carbon dioxide bomb (cylinder) of the siphon type and a second piping connected to the outside via a back pressure valve. First and second valves were provided for the first and second pipings respectively. The both valves were closed in the initial valve state. 80 g of a pellet of block copolymer having hydrophilic segment (PL 1251 produced by Sanyo Chemical Industries, Ltd.) (raw material pellet) and 160 mg of hexafluoroacetylacetonatopalladium (II) (reagent produced by Aldrich) (electroless plating catalyst) were arranged in the pressure resistant vessel, followed by being hermetically sealed. The pressure resistant vessel was cooled to 10°C. The first valve was opened to introduce liquid carbon dioxide into the pressure resistant vessel via the first piping. It was confirmed that the pressure in the pressure resistant vessel was 4.5 MPa, and then the first valve was closed. Subsequently, the back pressure valve was set to 10 MPa, and then the second valve was opened to heat the pressure resistant vessel. The pressure was retained at 10 MPa and the temperature was retained at 40°C in the pressure resistant vessel. In this state, the pressure resistant vessel was heated for 2 hours while opening the second valve. After stopping the heating, the pressure resistant vessel was left to stand for 5 hours, and the temperature of the pressure resistant vessel was lowered to room temperature. After that, the back pressure valve was opened, and carbon dioxide was released from the pressure resistant vessel. After the pressure in the pressure resistant vessel returned to the atmospheric pressure, the pellet of the block copolymer (first resin pellet), into which hexafluoroacetylacetonatopalladium permeated, was taken out from the pressure resistant vessel.

The pellet, which was taken out from the vessel, was visually observed. The pellet was colorless before the foregoing treatment. However, the pellet after the foregoing treatment was colored to yellow. According to this fact, it was possible to confirm that hexafluoroacetylacetonatopalladium (II) was impregnated into the pellet of the block copolymer.

### (b) Molding of molded product

66 nylon (Amilan (trade name) CM3001 G33 produced by Toray Industries, Inc.) containing 33% by weight of glass fiber was used as the second resin pellet. The resin pellets were mixed at a ratio of 10% by weight of the obtained first resin pellet and 90% by weight of the second resin pellet. The mixed pellets were molded into a plate-shaped member of 4 cm x 8 cm x 0.2 cm by using a general purpose injection molding machine (J180AD-300H produced by The Japan Steel Works, Ltd.) which was the same as or equivalent to that of Example 1.

### (2) Application of iodine and laser drawing

In accordance with a method which was the same as or equivalent to that of Example 1, Iodine was applied to the resin molded product, after that, the laser drawing was performed.

### (3) Plating pretreatment

Before the electroless plating, the base member, which was subjected to the laser drawing, was immersed in hydrochloric acid (3.0 N) for 5 minutes at the ordinary temperature. As a result of this plating pretreatment, the surface of 66 nylon in the base member was swelled, and the plating solution was easily permeated into the base member in the electroless plating treatment to be performed in the step carried out thereafter.

### (4) Electroless plating

Subsequently, the electroless plating was performed for the resin molded product having been subjected to the plating pretreatment, in accordance with a method which was the same as or equivalent to that of Example 1. The resin molded product was observed during the electroless plating. As a result, bubbles appeared at only the portion subjected to the laser drawing of the resin molded product. It was speculated that the bubbles were hydrogen. According to this fact, it was possible to confirm that the electroless plating reaction was caused at only the portion subjected to the laser drawing.

### (5) Reduction and removal of iodine

Iodine was removed from the resin molded product (base member) in accordance with a method which was the same as or equivalent to that of Example 1.

### <Evaluation>

The plated part, which was produced in accordance with the production method as explained above, was visually observed. In the case of the plated part of Example 5, the plating film was formed at only the portion for which the laser drawing was performed. Any deposition of the plating film was not observed at the portions other than the heated portion. It is postulated that the plating film was formed at the predetermined pattern portion, because the surface of the molded product was roughened by the irradiation with the laser beam, and thus the electroless plating catalyst, which was not poisoned by iodine, was exposed to the base member surface, while the permeation of the electroless plating solution into the base member was facilitated, and the reactivity of the electroplating was improved. On the other hand, it is speculated that the generation of the electroless plating film was suppressed on account of the presence of iodine at the portions other than the predetermined pattern.

Subsequently, the electric resistance was measured at the portion subjected to the laser drawing. As a result of the measurement of the electric resistance in accordance with a method which was the same as or equivalent to that of Example 1, the electric resistance was 10 **Ω** which was a low value. It was possible to confirm that the portion formed with the plating film had the conductivity.

### [Comparative Example 1]

In Comparative Example 1, the application of iodine to the base member (Step (2) in Example 1) and the reduction and removal of iodine (Step (6) in Example 1) were not performed. A plated part, on which a plating film was formed, was produced in accordance with a method which was the same as or equivalent to that of Example 1 other than the above. However, in Comparative Example 1, when the resin molded product was observed during the electroless plating, bubbles were vigorously generated from the entire surface of the base member. Therefore, in order to avoid the decomposition of the plating solution, the immersion time for immersing the base member in the electroless plating solution was 30 seconds shorter than that of Example 1.

### <Evaluation>

The plated part, which was produced in accordance with the production method as explained above, was visually observed. In the case of the plated part of Comparative Example 1, the plating film was formed on the entire surface of the base member. Further, when the portion subjected to the laser drawing was compared with the other portions, no difference was found in the growth of the plating film. In Comparative Example 1, the application of iodine to the base member was not performed. Therefore, the electroless plating catalyst was not poisoned. Therefore, it is speculated that the plating film was generated on the entire surface of the base member irrelevant to the presence or absence of the irradiation with the laser beam.

### [Comparative Example 2]

In Comparative Example 2, the application of iodine to the base member (Step (2) in Example 1) and the reduction and removal of iodine (Step (6) in Example 1) were not performed. A plated part, on which a plating film was formed, was produced in accordance with a method which was the same as or equivalent to that of Example 5 other than the above. However, in Comparative Example 2, when the resin molded product was observed during the electroless plating, bubbles were vigorously generated from the entire surface of the base member. Therefore, in order to avoid the decomposition of the plating solution, the immersion time for immersing the base member in the electroless plating solution was 5 minutes shorter than that of Example 5.

### <Evaluation>

The plated part, which was produced in accordance with the production method as explained above, was visually observed. In the case of the plated part of Comparative Example 2, the plating film was formed on the entire surface of the base member. Further, when the portion subjected to the laser drawing was compared with the other portions, no difference was found in the growth of the plating film. In Comparative Example 2, the application of iodine to the base member was not performed. Therefore, the electroless plating catalyst was not poisoned. Therefore, it is speculated that the plating film was generated on the entire surface of the base member irrelevant to the presence or absence of the irradiation with the laser beam.

### [Comparative Example 3]

In Comparative Example 3, the respective treatments were carried out for the base member in the same manner as Example 1, except that the laser drawing (Step (3) in Example 1) was not performed. However, in Comparative Example 3, no electroless plating film was generated on the base member surface. In Comparative Example 3, the application of iodine to the base member was performed, and then the heating of the base member based on the use of the laser beam or the like was not performed. Therefore, a state was given, in which iodine permeated into the entire surface of the base member. It is speculated that the generation of the electroless plating film was suppressed due to the presence of iodine.

### [Example 6]

In Example 6, the electroless plating catalyst was applied to the base member in accordance with the sensitizer-activator method, and an electroless copper plating solution was used as the electroless plating solution. Further, the removal of the catalyst inactivator was not performed. A plated part, in which a plating film was selectively formed, was produced in accordance with a method which was the same as or equivalent to that of Example 1.

### (1) Molding of resin molded product and application of iodine

In accordance with a method which was the same as or equivalent to that of Example 1, at first, a resin molded product was molded as the base member, and then iodine was applied to the resin molded product.

### (2) Laser drawing

The laser drawing was performed with a predetermined pattern on the resin molded product to which iodine was applied, under a laser drawing condition which was the same as or equivalent to that of Example 1 by using a laser drawing apparatus which was the same as or equivalent to that of Example 1. The drawn pattern is such a pattern that a plurality of areas of 5 mm x 5 cm were aligned at 0.1 mm pitches.

### (3) Application of electroless plating catalyst

The electroless plating catalyst was applied to the base member irradiated with the laser beam in accordance with the sensitizer-activator method by using a commercially available catalyst solution for the electroless plating which was the same as or equivalent to that of Example 2. The electroless plating catalyst was applied to the base member in accordance with a method which was the same as or equivalent to that of Example 2 except that the time for radiating the ultrasonic wave while immersing the base member in the sensitivity applying agent (sensitizer) was 5 minutes and the time for immersing the base member in the catalyzing treatment agent (activator) thereafter was 2 minutes.

### (4) Electroless plating

The molded product, to which the electroless plating catalyst was applied, was immersed in an electroless copper plating solution (OPC-NCA produced by OKUNO CHEMICAL INDUSTRIES CO., LTD.) at 60°C for 15 minutes to form an electroless copper plating film having a thickness of 1 µm on the molded product surface.

### <Evaluation>

The plated part, which was produced in accordance with the production method as explained above, was visually observed. In the case of the plated part of Example 6, the plating film was formed at only the predetermined pattern subjected to the laser drawing, and the deposition of the plating film was not found at portions other than the predetermined pattern. It is speculated that the electroless plating film was generated at the predetermined pattern portion because iodine was removed by the irradiation with the laser beam and iodine was not present, while the generation of the electroless plating film was suppressed by the presence of iodine at the portions other than the predetermined pattern.

### <XPS analysis>

The XPS (X-ray Photoelectron Spectroscopy) analysis was performed for the portion of the plated part produced in Example 6 at which the plating film was formed and for the portion at which the plating film was not formed. However, the analysis depth of the XPS analysis is several nm. If the plating film is present, it is impossible to detect the catalyst or the like. Therefore, in this analysis, the procedure was carried out up to the step of catalyst application. A sample, on which the electroless plating film was not formed, was used as an analysis sample.

### (1) Analysis sample and analysis apparatus

The following three types of Samples A to C were prepared as analysis samples.

### Sample A: laser beam-irradiated portion

The base member was subjected to the application of iodine, the laser drawing, the application of the electroless plating catalyst, and the laser drawing. The portion subjected to the laser drawing was used as a sample piece.

### Sample B: laser beam-unirradiated portion

The base member was subjected to the application of iodine, the laser drawing, the application of the electroless plating catalyst, and the laser drawing. The portion other than the portion subjected to the laser drawing was used as a sample piece.

### Sample C: reference (not applied with iodine)

Sample C was prepared in the same manner as Sample B except that iodine was not applied to the base member.

The laser beam-irradiated portion of Sample A is the portion at which the electroless plating film is formed when the electroless plating solution is brought into contact therewith. The laser beam-unirradiated portion of Sample B is the portion at which the electroless plating film is not formed even when the electroless plating solution is brought into contact therewith. An XPS analysis apparatus (ESCA 5500MC produced by ULVAC-PHI, INCORPORATED, excitation source: MgKa 1253.6 eV, analysis area: φ800 µm)was used for the analysis.

### (2) Analysis result

### (a) Element concentration on sample surface

Table 1 shows the element concentrations on each of the sample surfaces.

**Table 1**

| | Element concentration (at%) | | | | | | | |
|---|---|---|---|---|---|---|---|---|
| | C | O | N | Pd | Sn | I | Cl | Si |
| Sample A (laser beam-irradiated portion) | 58.1 | 26.6 | 3.0 | 1.5 | 8.4 | 0.6 | 1.8 | 0.0 |
| Sample A (laser beam-unirradiated portion) | 51.7 | 28.1 | 3.2 | 2.7 | 8.1 | 6.1 | 0.0 | 0.0 |
| Sample C (reference) | 57.2 | 27.9 | 3.7 | 2.0 | 7.5 | 0.0 | 1.0 | 0.8 |

C, O, N, and Si, which were detected from all of samples A to C, are the constitutive elements of nylon 6T and the glass fiber contained in the base member. In relation to Samples A to C, the concentrations of the elements originating from the base member were slightly dispersed. However, it was judged that the dispersion was caused by the exposure situation of the glass fiber on the base member surface and the protrusions and recesses (irregularities) of the surface brought about by the laser drawing, and the dispersion was not any significant difference.

Iodine (I) was detected from Samples A and B to which iodine was applied. The iodine concentration of Sample A subjected to the irradiation with the laser beam was about 10% of the iodine concentration of Sample B not subjected to the irradiation with the laser beam, and the significant difference was found. According to this result, it was revealed that iodine was removed from the base member by means of the irradiation with the laser beam.

Pd, Sn, and Cl are the elements contained in the catalyzing treatment agent (activator) and the sensitivity applying agent (sensitizer) as the catalyst solution for the electroless plating. As for Pd and Sn, there was a somewhat difference in the detection amount in relation to each of the samples. However, it was judged that any significant difference was not provided in the same manner as the elements originating from the base member. Sn was also detected from any one of the samples of Samples A to C. In relation to Samples A and C, it is speculated that Sn exists as SnCl₂ contained in the sensitizer or as SnCl₄ generated by the reaction of the same with Pd²⁺ contained in the activator. On the other hand, Cl was not detected from Sample B (laser beam-unirradiated portion). In the case of Sample B, a larger amount of iodine (I) exists as compared with the other samples. On this account, it is speculated that Sn reacts with iodine not with Cl and Sn exists as SnI₂ or SnI₄ in Sample B.

### (b) Chemical state of electroless plating catalyst

Pd3d spectrums of the respective samples were detected and separated. According to the library database of the spectrums, 337.6 eV was attributed to Pd complex, 336.6 eV was attributed to palladium oxide or palladium iodide, and 335.3 eV was attributed to metal Pd having the oxidation number of 0. Metal Pd has the catalytic ability. On the other hand, Pd, which exists as palladium oxide or palladium iodide, is Pd which is in such a state that the catalytic ability is inactivated (catalytic activity-inactivated state). Further, Pd complex is Pd complex (palladium chloride, palladium acetate, palladium sulfate) contained in the activator. Table 2 shows the ratios of the respective chemical states of Pd in the respective samples.

**Table 2**

| | Ratio (at%) | | |
|---|---|---|---|
| | 337.6 eV | 336.6 eV | 335.3 eV |
| | Pd complex | PdO, PdI₂ | Metal Pd |
| Sample A (laser beam-irradiated portion) | 12.5 | 26.2 | 61.3 |
| Sample B (laser beam-unirradiated portion) | 7.2 | 73.0 | 19.8 |
| Sample C (reference) | 38.5 | 4.8 | 56.8 |

As shown in Table 2, in the case of Sample A (laser beam-irradiated portion), the ratio of metal Pd was not less than 60% which was large, and Pd in the catalytic activity-inactivated state was 26.2% which was small. On the other hand, in the case of Sample B (laser beam-unirradiated portion), the ratio of Pd in the catalytic activity-inactivated state was not less than 70% which was large, and the ratio of metal Pd was less than 20% which was small. In this way, it has been revealed that there is a difference in the concentration of metal Pd having the electroless plating catalytic ability, depending on the presence or absence of the laser irradiation, and hence any difference arises in the deposition performance of the plating, which makes it possible to perform the selective plating.

In the case of Sample B in which the amount of Pd in the catalytic activity-inactivated state is large, the iodine element concentration is high as compared with the other samples. On the other hand, Pd in the catalytic activity-inactivated state was hardly detected (less than 5%) from Sample C from which the iodine element was not detected. According to this result, it is speculated that the inactivation of the catalytic ability of palladium is caused by iodine, and Pd was reacted with iodine to form palladium iodide or Pd was oxidized into palladium oxide.

### [Example 7]

In Example 7, a resin molded product, which had a first pattern formed by protrusions on a surface, was used as the base member to produce a plated part in which a plating film was selectively formed on the first pattern.

### (1) Molding of resin molded product and application of iodine

At first, a flat plate having a length of 100 mm x a width of 200 mm x a thickness of 3 mm, in which the first pattern was formed by protrusions on one surface, was molding by using a thermoplastic resin and an injection molding machine which were the same as or equivalent to those of Example 1. The first pattern was formed on the molded product surface simultaneously with the molding of the molded product by molding the molded product by using a mold having trapezoidal straight grooves formed on the surface. As shown in Fig. 6(b), the width of the protrusion (base of the trapezoid) W was 1 mm, the height H was 1 mm, and the pitch P was 2 mm. Further, the length of the protrusion was 50 mm. The first pattern, which included ten protrusions on the surface of the base member, was formed. Subsequently, iodine was applied to the resin molded product in accordance with a method which was the same as or equivalent to that of Example 1. On account of the permeation of iodine into the base member, the base member surface was discolored to brown.

### (2) Heating of base member

The base member 60 was thermally pressed (hot-pressed) as shown in Fig. 7(a) by using a hot emboss apparatus (AHHE 0101 produced by Engineering System). A press plate including a flat plate-shaped aluminum steel material, in which a surface 70a to make contact with the protrusions 61 was flat, was used as a heating plate 70 for heating the protrusions 61. At first, the base member 60 was arranged between the upper press plate (heating plate) 70 and a lower press plate (not shown) so that the protrusions 61 are opposed to the upper press plate (heating plate) 70. Then, the temperature of the upper press plate (heating plate) 70 was 180°C, and the temperature of the lower press plate was room temperature (25°C). The base member 60 was thermally pressed, while the press time was 10 seconds and the press stroke was 10 µm. The top portion 61a of the protrusion 61, which was thermally pressed by the upper press plate (heating plate) 70, was discolored from brown to white. According to this fact, it is speculated that iodine having been present at the top portion 61a was evaporated and removed by the heating.

### (3) Application of electroless plating catalyst

The electroless plating catalyst was applied to a thermally pressed base member in accordance with the sensitizer-activator method by using a commercially available catalyst solution for the electroless plating which was the same as or equivalent to that of Example 2. The electroless plating catalyst was applied to the base member in accordance with a method which was the same as or equivalent to that of Example 2 except that the time was 5 minutes for immersing the base member in the sensitivity applying agent (sensitizer) and applying the ultrasonic wave thereto.

### (4) Electroless plating

An electroless copper plating film having a thickness of about 1 µm was formed on the molded product surface in accordance with a method which was the same as or equivalent to that of Example 6.

### <Evaluation>

The plated part, which was produced in accordance with the production method as explained above, was visually observed. In the case of the plated part of Example 7, the plating film was formed at only the top portion 61a of the protrusion 61 for forming the first pattern. The deposition of the plating film was not found at portions other than the heated portion. It is speculated that the electroless plating film was generated at the first pattern portion because iodine was not present as a result of the removal by being heated, while the generation of the electroless plating film was suppressed on account of the presence of iodine at the portions other than the first pattern.

A copper electroplating film of 20 µm was further stacked on the electroless plating film in accordance with a general purpose method, and the adhesion strength of the thin wire-shaped plating film was measured by means of a vertical tensile test. As a result, the adhesion strength of the plating film, which was converted into the adhesion strength per 1 cm width, was about 4 N/cm. Further, a heat shock test was performed for the plated part formed with the copper electroplating film, in which the procedure for allowing the plated part to be left to stand for 30 minutes in an environment at 120°C and the procedure for allowing the plated part to be left to stand for 30 minutes in an environment at -30°C were alternately repeated 1000 times. As a result, neither exfoliation nor blister of the plating film of the plated part was caused.

### [Example 8]

In Example 8, a plated part, in which a plating film was selectively formed on a first pattern, was produced by using a resin molded product as the base member having the first pattern formed by protrusions on a surface in the same manner as Example 7. However, in Example 8, unlike Example 7, a heating plate was used, which had a second pattern including protruding portions formed on the surface.

### (1) Molding of resin molded product and application of iodine

The resin molded product, which had the first pattern formed by the protrusions on one surface, was molded as the base member in accordance with a method which was the same as or equivalent to that of Example 7, and iodine was applied to the resin molded product in accordance with a method which was the same as or equivalent to that of Example 1. As a result of the permeation of iodine into the base member, the base member surface was discolored to brown.

### (2) Heating of base member

The base member 60 was thermally pressed (hot pressed) as shown in Fig. 8(a) by using a hot emboss apparatus which was the same as or equivalent to that of Example 7. A heating plate 90 for heating the protrusions 61 is a flat plate-shaped press plate including aluminum steel material, and the heating plate 90 has the protruding portions 91 extending on a surface 90a to make contact with the base member 60. The protruding portions 91 form the second pattern corresponding to the first pattern of the base member 60 on the surface 90a. In Example 8, the second pattern, which was formed by the protruding portions 91 of the heating plate 90, was brought into contact with the first pattern which was formed by the protrusions 61 of the base member 60 to thermally press the base member 60 by means of the heating plate 90. The condition of thermal press (hot press) was the same as or equivalent to that of Example 7. Depressions 61b, which corresponded to the protruding portions 91, were formed at the top portions 61a of the protrusions 61 pressed by the upper press plate (heating plate) 90. Further, the top portion 61a was discolored from brown to white. According to this fact, it is speculated that iodine having been present at the top portion 61a was evaporated and removed by the heating.

### (3) Application of electroless plating catalyst and electroless plating

In accordance with a method which was the same as or equivalent to that of Example 7, the electroless plating catalyst was applied to the thermally pressed base member (sensitizer-activator method) to form a copper electroless plating film having a thickness of about 1 µm on the surface of the molded product applied with the plating catalyst.

### <Evaluation>

The plated part, which was produced in accordance with the production method as explained above, was visually observed. In the case of the plated part of Example 8, the plating film was formed at only the inside of the depression 61b of the protrusion 61 for forming the first pattern as the heated portion. The deposition of the plating film was not found at portions other than the heated portion. It is speculated that the electroless plating film was generated at the portion of the first pattern because iodine was removed by being heated and iodine was not present, while the generation of the electroless plating film was suppressed on account of the presence of iodine at the portions other than the first pattern.

A copper electroplating film of 20 µm was further stacked on the electroless plating film in accordance with a general purpose method in the same manner as Example 7, and the adhesion strength of the thin wire-shaped plating film was measured by means of a vertical tensile test. As a result, the adhesion strength of the plating film, which was converted into the adhesion strength per 1 cm width, was about 8 N/cm. It was revealed that the adhesion strength was higher than the adhesion strength of the plating film of Example 7, for the following reason. That is, in the case of Example 8, it is speculated that the adhesion strength of the plating film was improved by adopting the structure in which the plating film was buried in the depression 61b.

### [Example 9]

In Example 9, triphenylantimony dichloride was used as the catalyst inactivator, the electroless plating catalyst was applied to the base member in accordance with the sensitizer-activator method, and the copper electroless plating solution was used as the plating solution. A plated part, in which a plating film was selectively formed, was produced in accordance with a method which was the same as or equivalent to that of Example 1 except for the above.

### (1) Molding of resin molded product

A resin molded product was molded as the base member in accordance with a method which was the same as or equivalent to that of Example 1.

### (2) Application of catalyst inactivator

196.0 g of methyl ethyl ketone (reagent produced by Wako Pure Chemical Industries, Ltd.) was added to 4.0 g of triphenylantimony dichloride (reagent produced by Tokyo Kasei Kogyo Co., Ltd.), followed by being agitated to prepare 2% triphenylantimony dichloride. The base member was immersed in this solution. After that, the base member was vertically pulled up from the solution, followed by being dried so that triphenylantimony dichloride was allowed to adhere to the surface.

### (3) Laser drawing

The laser drawing was performed with a predetermined pattern on the base member to which triphenylantimony dichloride was allowed to adhere, in accordance with a method which was the same as or equivalent to that of Example 1.

### (4) Electroless plating

A copper electroless plating film having a thickness of 7 µm was formed by performing the electroless plating for the base member applied with the electroless plating catalyst in accordance with a method which was the same as or equivalent to that of Example 3.

### (5) Removal of catalyst inactivator

500 cc of methyl ethyl ketone was introduced into a tall beaker. The base member after the plating was immersed therein, followed by being washed for 3 minutes while performing the shaking. Further, methyl ethyl ketone was replaced with a new liquid of the same to perform the washing again, followed by being dried at the ordinary temperature.

### <Evaluation>

The plated part, which was produced in accordance with the production method as explained above, was visually observed. In the case of the plated part of Example 9, the plating film was formed at only the portion subjected to the laser drawing, and the deposition of the plating film was not found at portions other than the portion subjected to the laser drawing. It is speculated that the electroless plating film was generated at the portion of the predetermined pattern because triphenylantimony dichloride was removed and triphenylantimony dichloride was not present, while the generation of the electroless plating film was suppressed on account of the presence of triphenylantimony dichloride at the portions other than the predetermined pattern.

### INDUSTRIAL APPLICABILITY

According to the method for producing the plated part of the present invention, the generation of the plating film can be suppressed at the portions other than the predetermined pattern, and the plating film can be formed at only the predetermined pattern in accordance with the simple and easy production process for the base member of various materials. Therefore, the present invention can be utilized to produce electronic parts having electric circuits and three-dimensional circuit parts (MID: Molded Interconnect Device).

### PARTS LIST

60: base member, 61: protrusion, 61a: top portion of protrusion, 61b: depression, 62: recess, 62a: bottom of recess, 70, 90: heating plate, 85: electroless plating film, 100, 200, 300, 400: plated part.

## Claims

1. A method for producing a plated part, comprising:
(a) applying a catalyst inactivator to a surface of a base member, the catalyst inactivator directly reacting with an electroless plating catalyst to prevent the electroless plating catalyst from exerting catalytic ability;
(b) irradiating with light or heating a part of the surface of the base member to which the catalyst inactivator is applied, the light being a laser beam;
(c) applying the electroless plating catalyst to the surface of the base member by bringing a catalyst solution in which the electroless plating catalyst is dissolved into contact with the surface of the base member, thereby bringing the electroless plating catalyst dissolved in the catalyst solution into contact with the catalyst inactivator; and
(d) bringing an electroless plating solution into contact with the surface of the base member retaining the electroless plating catalyst to form an electroless plating film at a light-irradiated portion or a heated portion of the surface,
wherein the steps (a) to (d) are performed in order.

2. The method for producing the plated part according to claim 1, wherein the catalyst inactivator is selected from the group consisting of iodine, zinc, lead, tin, bismuth, antimony, and a compound thereof.

3. The method for producing the plated part according to claim 1 or claim 2, wherein the catalyst inactivator is iodine.

4. The method for producing the plated part according to any one of claims 1 to 3, wherein the catalyst inactivator permeates into or adsorbs to the base member by applying the catalyst inactivator to the surface of the base member.

5. The method for producing the plated part according to any one of claims 1 to 4, wherein the step (a) of applying of the catalyst inactivator to the surface of the base member comprises:
preparing a catalyst inactivator solution containing the catalyst inactivator and a solvent; and
immersing the base member in the catalyst inactivator solution.

6. The method for producing the plated part according to claim 5, wherein the catalyst inactivator is iodine, the catalyst inactivator solution is an iodine solution; and the iodine solution further contains an iodide ion.

7. The method for producing the plated part according to any one of claims 1 to 6, wherein the catalyst inactivator is removed from the light-irradiated portion or the heated portion of the surface by irradiating with light or heating the part of the surface of the base member.

8. The method for producing the plated part according to any one of claims 1 to 7, wherein the electro less plating catalyst is applied to the surface of the base member after the part of the surface of the base member is irradiated with light or heated.

9. The method for producing the plated part according to any one of claims 1 to 8, wherein the irradiating with light or heating of the part of the surface of the base member is performing laser drawing on the surface of the base member by using the laser beam.

10. The method for producing the plated part according to any one of claims 1 to 8, wherein the base member has an area in which a predetermined first pattern is formed by protrusions and/or recesses extending on the surface;
the catalyst inactivator is applied to the area; and
the protrusions and/or the recesses, which form the first pattern, are irradiated with light or heated.

11. The method for producing the plated part according to claim 10, wherein the base member has the area in which the predetermined first pattern is formed by the protrusions extending on the surface; and
the protrusions are heated by bringing a heating plate into contact with the protrusions which form the first pattern.

12. The method for producing the plated part according to claim 11, wherein a second pattern, which corresponds to the first pattern of the base member, is formed on a surface of the heating plate by protruding portions existing on the surface; and
the second pattern, which is formed by the protruding portions of the heating plate, is brought into contact with the first pattern which is formed by the protrusions of the base member to thermally press the base member by the heating plate so that the protrusions are heated and depressions are formed at top portions of the protrusions.

13. The method for producing the plated part according to any one of claims 1 to 12, further comprising removing the catalyst inactivator from the base member after the electroless plating catalyst is retained or after the electroless plating film is formed.

14. The method for producing the plated part according to any one of claims 1 to 13, wherein the electroless plating catalyst contains Pd.

15. The method for producing the plated part according to any one of claims 1 to 14, wherein the electroless plating film forms an electric circuit on the base member, and the plated part is an electronic part.

## Patentansprüche

1. Verfahren zur Herstellung eines plattierten Teils, umfassend:
(a) Aufbringen eines Katalysatorinaktivators auf eine Oberfläche eines Grundelements, wobei sich der Katalysatorinaktivator direkt mit einem stromlos plattierenden Katalysator umsetzt, um zu verhindern, dass der stromlos plattierende Katalysator katalytische Fähigkeit ausübt;
(b) Bestrahlen mit Licht oder Erwärmen eines Teils der Oberfläche des Grundelements, auf welche der Katalysatorinaktivator aufgebracht wird, wobei das Licht ein Laserstrahl ist;
(c) Aufbringen des stromlos plattierenden Katalysators auf die Oberfläche des Grundelements durch Inkontaktbringen einer Katalysatorlösung, in welcher der stromlos plattierende Katalysator gelöst ist, mit der Oberfläche des Grundelements, wodurch der stromlos plattierende Katalysator, gelöst in der Katalysatorlösung, mit dem Katalysatorinaktivator in Kontakt gebracht wird; und
(d) Inkontaktbringen einer stromlos plattierenden Lösung mit der Oberfläche des Grundelements, die den stromlos plattierenden Katalysator zurückhält, um einen stromlos plattierenden Film an einem mit Licht bestrahlten Anteil oder einem erwärmten Anteil der Oberfläche zu bilden,
wobei die Schritte (a) bis (d) in Reihenfolge durchgeführt werden.

2. Verfahren zur Herstellung des plattierten Teils gemäß Anspruch 1, wobei der Katalysatorinaktivator aus der Gruppe ausgewählt ist, welche aus Iod, Zink, Blei, Zinn, Bismut, Antimon und einer Verbindung davon besteht.

3. Verfahren zur Herstellung des plattierten Teils gemäß Anspruch 1 oder Anspruch 2, wobei der Katalysatorinaktivator Iod ist.

4. Verfahren zur Herstellung des plattierten Teils gemäß einem der Ansprüche 1 bis 3, wobei der Katalysatorinaktivator durch Aufbringen des Katalysatorinaktivators auf die Oberfläche des Grundelements in das Grundelement permeiert oder daran adsorbiert.

5. Verfahren zur Herstellung des plattierten Teils gemäß einem der Ansprüche 1 bis 4, wobei der Schritt (a) von Aufbringen des Katalysatorinaktivators auf die Oberfläche des Grundelements umfasst:
Herstellen einer Katalysatorinaktivator-Lösung, welche den Katalysatorinaktivator und ein Lösungsmittel enthält; und
Eintauchen des Grundelements in die Katalysatorinaktivator-Lösung.

6. Verfahren zur Herstellung des plattierten Teils gemäß Anspruch 5, wobei der Katalysatorinaktivator Iod ist, die Katalysatorinaktivator-Lösung eine Iodlösung ist; und die Iodlösung ferner ein Iodidion enthält.

7. Verfahren zur Herstellung des plattierten Teils gemäß einem der Ansprüche 1 bis 6, wobei der Katalysatorinaktivator von dem mit Licht bestrahlten Anteil oder dem erwärmten Anteil der Oberfläche durch Bestrahlen mit Licht oder Erwärmen des Teils der Oberfläche des Grundelements entfernt wird.

8. Verfahren zur Herstellung des plattierten Teils gemäß einem der Ansprüche 1 bis 7, wobei der stromlos plattierende Katalysator auf die Oberfläche des Grundelements aufgebracht wird, nachdem der Teil der Oberfläche des Grundelements mit Licht bestrahlt oder erwärmt wurde.

9. Verfahren zur Herstellung des plattierten Teils gemäß einem der Ansprüche 1 bis 8, wobei das Bestrahlen mit Licht oder Erwärmen des Teils der Oberfläche des Grundelements Durchführen von Laserzeichnen auf der Oberfläche des Grundelements unter Verwendung des Laserstrahls ist.

10. Verfahren zur Herstellung des plattierten Teils gemäß einem der Ansprüche 1 bis 8, wobei das Grundelement eine Fläche aufweist, in welcher ein vorher bestimmtes erstes Muster durch Vorsprünge und/oder Vertiefungen, die sich auf der Oberfläche erstrecken, gebildet wird;
der Katalysatorinaktivator auf die Fläche aufgebracht wird; und
die Vorsprünge und/oder die Vertiefungen, die das erste Muster bilden, mit Licht bestrahlt oder erwärmt werden.

11. Verfahren zur Herstellung des plattierten Teils gemäß Anspruch 10, wobei das Grundelement die Fläche aufweist, in welcher das vorher bestimmte erste Muster durch die Vorsprünge, die sich auf der Oberfläche erstrecken, gebildet wird; und
die Vorsprünge erwärmt werden durch Inkontaktbringen einer Wärmeplatte mit den Vorsprüngen, welche das erste Muster bilden.

12. Verfahren zur Herstellung des plattierten Teils gemäß Anspruch 11, wobei ein zweites Muster, welches dem ersten Muster des Grundelements entspricht, auf einer Oberfläche der Wärmeplatte durch vorspringende Anteile, die auf der Oberfläche vorhanden sind, gebildet wird; und
das zweite Muster, welches durch die vorspringenden Anteile der Wärmeplatte gebildet wird, mit dem ersten Muster, welches durch die Vorsprünge des Grundelements gebildet wird, in Kontakt gebracht wird, um auf das Grundelement durch die Wärmeplatte thermisch Druck aufzubringen, so dass die Vorsprünge erwärmt werden und Einsenkungen an oberen Anteilen der Vorsprünge gebildet werden.

13. Verfahren zur Herstellung des plattierten Teils gemäß einem der Ansprüche 1 bis 12, ferner umfassend Entfernen des Katalysatorinaktivators von dem Grundelement, nachdem der stromlos plattierende Katalysator zurückgehalten wurde oder nachdem der stromlos plattierende Film gebildet wurde.

14. Verfahren zur Herstellung des plattierten Teils gemäß einem der Ansprüche 1 bis 13, wobei der stromlos plattierende Katalysator Pd enthält.

15. Verfahren zur Herstellung des plattierten Teils gemäß einem der Ansprüche 1 bis 14, wobei der stromlos pattierende Film einen elektrischen Schaltkreis auf dem Grundelement bildet, und der/das plattierte Teil ein elektronischer/elektronisches Teil ist.

## Revendications

1. Procédé pour produire une pièce plaquée, comportant les étapes consistant à :
(a) appliquer un désactivateur de catalyseur sur une surface d'un élément de base, le désactivateur de catalyseur réagissant directement avec un catalyseur de dépôt non électrolytique pour empêcher le catalyseur de dépôt non électrolytique d'exercer une action catalytique,
(b) soumettre à une lumière ou chauffer une partie de la surface de l'élément de base sur laquelle le désactivateur de catalyseur est appliqué, la lumière étant un faisceau laser,
(c) appliquer le catalyseur de dépôt non électrolytique sur la surface de l'élément de base en mettant une solution catalytique dans laquelle le catalyseur de dépôt non électrolytique est dissout en contact avec la surface de l'élément de base, en mettant ainsi le catalyseur de dépôt non électrolytique dissout dans la solution catalytique en contact avec le désactivateur de catalyseur, et
(d) mettre une solution de dépôt non électrolytique en contact avec la surface de l'élément de base retenant le catalyseur de dépôt non électrolytique pour former un film de dépôt non électrolytique sur une portion soumise à la lumière ou une portion chauffée de la surface,
dans lequel les étapes (a) à (d) sont exécutées dans l'ordre.

2. Procédé pour produire la pièce plaquée selon la revendication 1, dans lequel le désactivateur de catalyseur est choisi parmi le groupe constitué de l'iode, du zinc, du plomb, de l'étain, du bismuth, de l'antimoine et d'un composé de ceux-ci.

3. Procédé pour produire la pièce plaquée selon la revendication 1 ou la revendication 2, dans lequel le désactivateur de catalyse est l'iode.

4. Procédé pour produire la pièce plaquée selon l'une quelconque des revendications 1 à 3, dans lequel le désactivateur de catalyseur s'infiltre dans l'élément de base ou est adsorbé sur celui-ci en appliquant le désactivateur de catalyseur sur la surface de l'élément de base.

5. Procédé pour produire la pièce plaquée selon l'une quelconque des revendications 1 à 4, dans lequel l'étape (a) d'application du désactivateur de catalyseur sur la surface de l'élément de base comporte les étapes consistant à :
préparer une solution de désactivateur de catalyseur contenant le désactivateur de catalyseur et un solvant, et
immerger l'élément de base dans la solution le désactivateur de catalyseur.

6. Procédé pour produire la pièce plaquée selon la revendication 5, dans lequel le désactivateur de catalyseur est l'iode, la solution de désactivateur de catalyseur est une solution iodée, et la solution iodée contient en outre un ion iodure.

7. Procédé pour produire la pièce plaquée selon l'une quelconque des revendications 1 à 6, dans lequel le désactivateur de catalyseur est retiré de la portion soumise à la lumière ou de la portion chauffée de la surface en soumettant à la lumière ou en chauffant la partie de la surface de l'élément de base.

8. Procédé pour produire la pièce plaquée selon l'une quelconque des revendications 1 à 7, dans lequel le catalyseur de dépôt non électrolytique est appliqué sur la surface de l'élément de base après que la partie de la surface de l'élément de base est soumise à la lumière ou chauffée.

9. Procédé pour produire la pièce plaquée selon l'une quelconque des revendications 1 à 8, dans lequel le fait de soumettre à la lumière ou de chauffer la partie de la surface de l'élément de base produit un dessin au laser sur la surface de l'élément de base en utilisant le faisceau laser.

10. Procédé pour produire la pièce plaquée selon l'une quelconque des revendications 1 à 8, dans lequel l'élément de base a une zone dans laquelle un premier motif prédéterminé est formé par des saillies et/ou des évidements s'étendant sur la surface,
le désactivateur de catalyseur est appliqué sur la zone, et
les saillies et/ou les évidements, qui forment le premier motif, sont soumis à la lumière ou chauffés.

11. Procédé pour produire la pièce plaquée selon la revendication 10, dans lequel l'élément de base a la zone dans laquelle le premier motif prédéterminé est formé par les saillies s'étendant sur la surface, et
les saillies sont chauffées en mettant une plaque chauffante en contact avec les saillies qui forment le premier motif.

12. Procédé pour produire la pièce plaquée selon la revendication 11, dans lequel un second motif, qui correspond au premier motif de l'élément de base, est formé sur une surface de la plaque chauffante par des portions saillantes existant sur la surface, et le second motif, qui est formé par les portions saillantes de la plaque chauffante, est mis en contact avec le premier motif qui est formé par les saillies de l'élément de base pour presser thermiquement l'élément de base par la plaque chauffante de sorte que les saillies sont chauffées et des creux sont formés sur des portions supérieures des saillies.

13. Procédé pour produire la pièce plaquée selon l'une quelconque des revendications 1 à 12, comportant en outre le retrait du désactivateur de catalyseur de l'élément de base après que le catalyseur de dépôt non électrolytique est retenu ou après que le film de dépôt non électrolytique est formé.

14. Procédé pour produire la pièce plaquée selon l'une quelconque des revendications 1 à 13, dans lequel le désactivateur de catalyseur non électrolytique contient du Pd.

15. Procédé pour produire la pièce plaquée selon l'une quelconque des revendications 1 à 14, dans lequel le film de dépôt non électrolytique forme un circuit électrique sur l'élément de base, et la pièce plaquée est une pièce électronique.
